# EUROPEAN PATENT APPLICATION

(11) **EP 4 734 723 A1**
(43) Date of publication of application: **29.04.2026**
(21) Application number: 24860205.4
(22) Date of filing: 30.07.2024
(51) Int. Cl.: H10K 59/80, H10K 77/10, G09F 9/30, H10K 102/00

(54) **FLEXIBLE DISPLAY AND ELECTRONIC DEVICE COMPRISING SAME**

(30) Priority: 01.09.2023 KR 20230116122; 12.10.2023 KR 20230135531
(71) Applicant: Samsung Electronics Co., Ltd., Suwon-si, Gyeonggi-do 16677 (KR)
(72) Inventor: LEE, Hojung, Suwon-si Gyeonggi-do 16677 (KR); LIM, Sunghwan, Suwon-si Gyeonggi-do 16677 (KR); CHO, Hyunmoon, Suwon-si Gyeonggi-do 16677 (KR); OH, Seungtaek, Suwon-si Gyeonggi-do 16677 (KR)
(74) Representative: HGF
(86) International application number: PCT/KR2024/011125
(87) International publication number: WO 2025/048284

(57) **Abstract**

An electronic device according to one embodiment may comprise: a first housing; a second housing coupled so as to be movable or rotatable with respect to the first housing; and a flexible display which is accommodated in the first housing and the second housing and configured such that at least a portion thereof is deformed. The flexible display may include a deformable display panel and a glass member which is positioned on the deformable display panel and configured to be deformable. The glass member may include, on at least one side surface thereof, a plurality of recesses formed inward from the outside of the glass member.

## Description

### [Technical Field]

Various embodiments of the disclosure relate to a flexible display and an electronic device including the same.

### [Background Art]

Recently, there is increasing interest in bendable electronic devices (hereinafter, 'flexible electronic devices') including a bendable flexible display or deformable display (hereinafter, 'flexible display'). The window member used in the flexible display requires flexibility for preventing deformation when folded or bent, as well as impact resistance due to surface hardness or strength.

The above-described information may be provided as related art for the purpose of helping understanding of the disclosure. The foregoing cannot be claimed as, or used to determine, the prior art related to the disclosure.

### [Disclosure of Invention]

### [Solution to Problems]

Various embodiments of the disclosure may prevent or reduce breakage of ultra-thin glass included in a flexible display due to foreign objects entering the interior of an electronic device.

An electronic device according to an embodiment may include a first housing, a second housing coupled to be movable or rotatable with respect to the first housing, and a flexible display received in the first housing and the second housing and configured such that at least a portion thereof is deformable. The flexible display may include a deformable display panel and a glass member positioned on the deformable display panel and configured to be deformable. The glass member may include a plurality of recesses formed inwardly from an outside of the glass member on at least one side surface.

According to various embodiments proposed in the disclosure, the flexible display may prevent or reduce breakage caused by foreign objects by forming a plurality of recesses near the edge of the flexible region of the glass member.

According to various embodiments proposed in the disclosure, the flexible display may prevent or reduce breakage caused by foreign objects by forming the portion near the edge of the flexible region of the glass member thicker than other portions.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a block diagram illustrating an electronic device in a network environment according to various embodiments.
FIG. 2A is a perspective view illustrating a foldable electronic device in an unfolding state according to an embodiment.
FIG. 2B is a perspective view illustrating a foldable electronic device in a folding state according to an embodiment.
FIG. 3 is an exploded view illustrating a foldable electronic device according to an embodiment.
FIG. 4 is a perspective view illustrating a stacked structure of a flexible display according to an embodiment.
FIG. 5 is a cross-sectional view taken along the periphery portion of an electronic device according to an embodiment.
FIG. 6 is a view illustrating a glass member according to an embodiment.
FIG. 7 is a cross-sectional view taken along line A-A of FIG. 6.
FIG. 8 is a view illustrating a glass member according to an embodiment.
FIG. 9 is a cross-sectional view taken along line B-B of FIG. 8.
FIG. 10 is a view illustrating a glass member according to an embodiment.
FIG. 11 is a cross-sectional view taken along line C-C of FIG. 10.
FIG. 12 is a cross-sectional view illustrating a flexible display according to an embodiment.
FIG. 13 is a view illustrating the magnitude of stress applied during bending of a flexible display according to an embodiment.
FIG. 14 is a graph illustrating strength according to thickness of a glass member according to an embodiment.
FIG. 15 is a graph illustrating relative repulsive force according to thickness of a glass member according to an embodiment.
FIG. 16 is an example for describing a method of forming a plurality of recesses in a glass member.
FIGS. 17A and 17B are examples for describing a method of forming a plurality of recesses in a glass member.
FIG. 18 is a flowchart illustrating a flexible display manufacturing method according to an embodiment.
FIGS. 19A to 19D are cross-sectional views illustrating shapes of a first glass portion of a glass member according to various embodiments.
FIGS. 20A to 20C are plan views illustrating planar shapes of a first glass portion of a glass member according to various embodiments.
FIGS. 21A to 21C are perspective views illustrating the first glass portion of a glass member according to various embodiments.
FIG. 22 is a perspective view illustrating a portion of a glass member according to an embodiment.
FIGS. 23A to 24D are views illustrating a process of applying an adhesive member to a glass member according to an embodiment.
FIGS. 25A to 25C are views illustrating applying an adhesive member to a glass member according to an embodiment.
FIG. 26 is a cross-sectional view illustrating a flexible display according to an embodiment.
FIG. 27 is a cross-sectional view illustrating a flexible display according to an embodiment.
FIGS. 28A and 28B are plan views illustrating a slidable electronic device according to an embodiment.
FIG. 29 is a view illustrating a glass member according to an embodiment.
FIG. 30 is a perspective view illustrating a foldable electronic device capable of folding multiple times according to an embodiment.
FIG. 31 is a view illustrating a glass member according to an embodiment.
FIG. 32 is a view illustrating a glass member according to an embodiment.
FIGS. 33A to 33C are cross-sectional views taken along line M-M in FIG. 32.

Reference may be made to the accompanying drawings in the following description, and specific examples that may be practiced are shown as examples within the drawings. Other examples may be utilized and structural changes may be made without departing from the scope of the various examples.

### [Mode for the Invention]

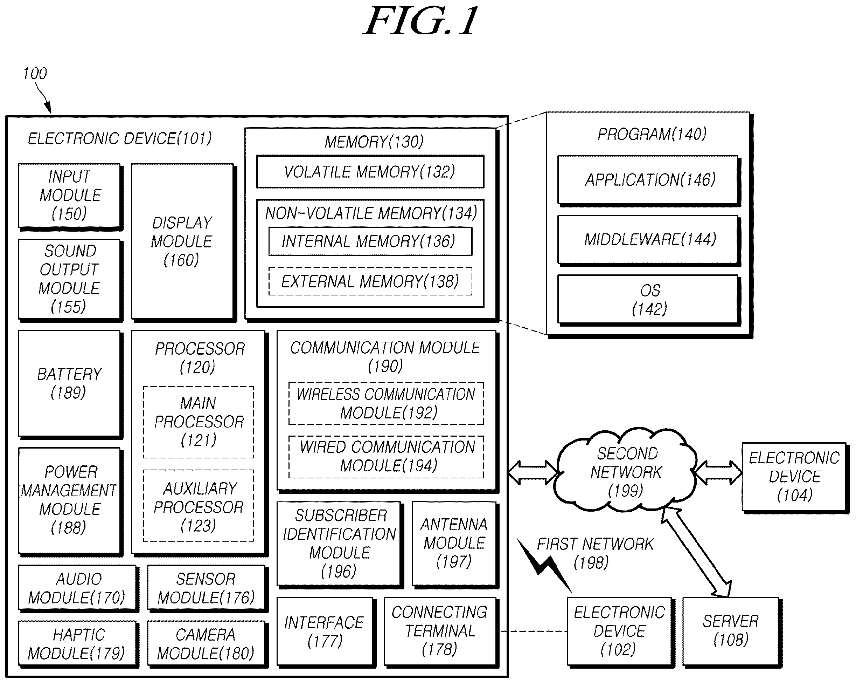

Various embodiments of the disclosure are merely exemplified herein with reference to FIGS. 1 to 33C, to describe the principle of the disclosure, and should not be interpreted as limiting the scope of the disclosure. Those skilled in the art will understand that the principle of the disclosure may be implemented in any appropriately disposed system or device.

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

FIG. 1 is a block diagram illustrating an electronic device 101 in a network environment 100, according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in case that the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

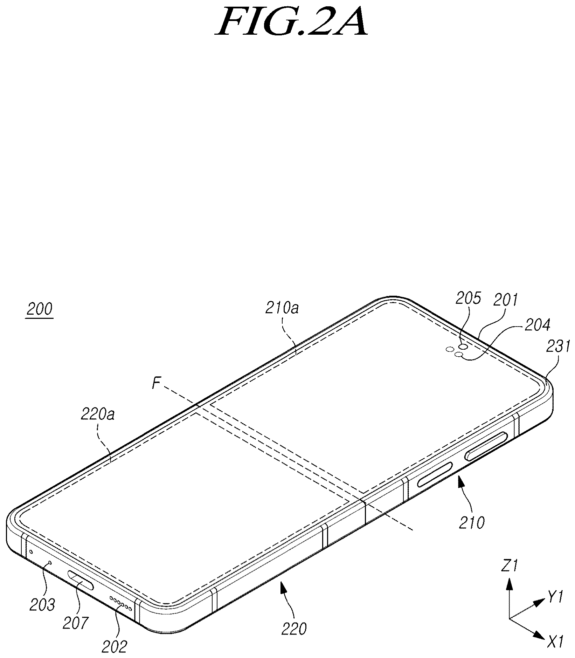

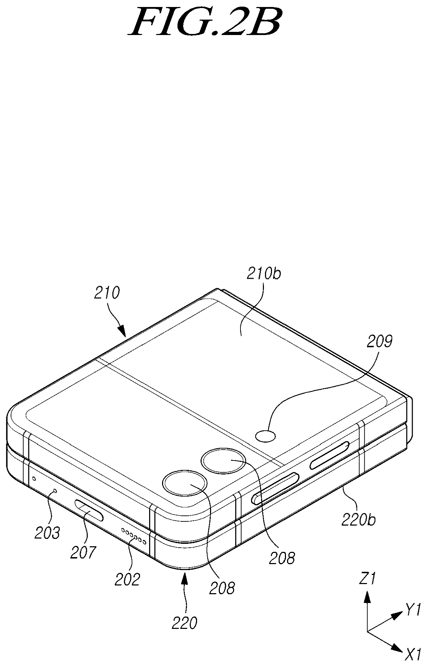

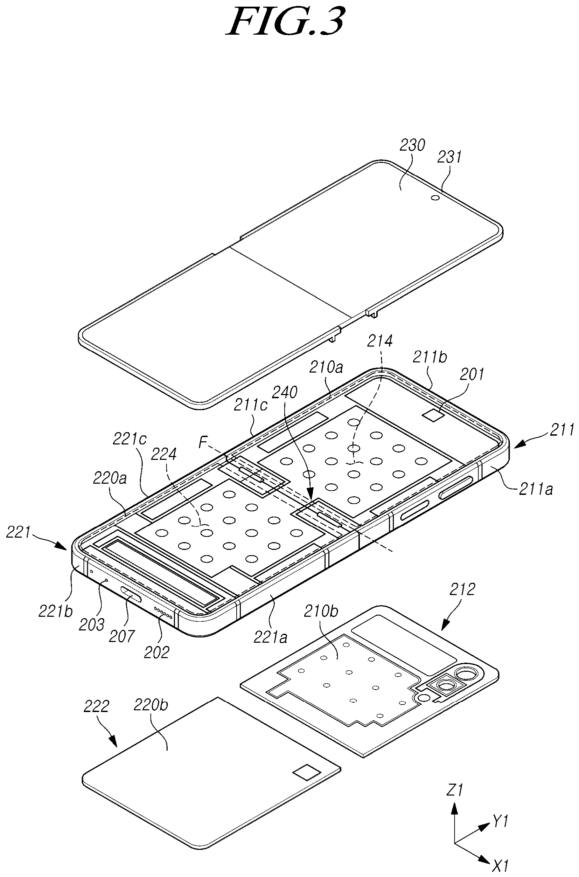

FIG. 2A is a perspective view illustrating a foldable electronic device in an unfolding state according to an embodiment. FIG. 2B is a perspective view illustrating a foldable electronic device in a folding state according to an embodiment. FIG. 3 is an exploded view illustrating a foldable electronic device according to an embodiment. The electronic device shown in FIGS. 2A to 3 is for illustrative purposes only, and the disclosure is not limited by the drawings. The X-Y-Z coordinate system shown in FIGS. 2A to 3 is for illustrative purposes of describing the layout of the components and does not limit the scope of the claims.

The electronic device 200 (e.g., the electronic device 101 of FIG. 1) may include at least one pair of housings 210 and 220. The pair of housings 210 and 220 may be rotatably coupled to fold with respect to each other, e.g., about a hinge (e.g., the hinge 240 of FIG. 3) while facing each other. For example, the pair of housings 210 and 220 may include a first housing 210 and a second housing 220. The first housing 210 and the second housing 220 may be disposed on two opposite sides of the folding axis F. One end area of the first housing 210 and one end area of the second housing 220 may be disposed side by side with the hinge 240 interposed therebetween. The first housing 210 and the second housing 220 may have symmetrical shapes with respect to a plane including the folding axis F and extending in the Z1-axis direction. Here, the folding axis F may be an axis in the X1 direction, formed by the hinge 240.

The first housing 210 may have substantially the same length as the second housing 220 (e.g., length in the Y1-axis direction), but is not limited thereto. The first housing 210 may have substantially the same width as the second housing 220 (e.g., width in the X1-axis direction), but is not limited thereto.

Hereinafter, 'unfolding state (or flat state)' or 'unfolded state' may refer to a state in which the angle between the first housing 210 and the second housing 220 is substantially 180 degrees. 'Folding state' or a 'folded state' may refer to a state in which the angle formed between the first housing 210 and the second housing 220 is substantially 0 degrees. 'Intermediate state' may refer to any state between the unfolding state and the folding state. The electronic device 200, for example, may rotate about the hinge 240 such that the first housing 210 and the second housing 220 form an angle from 0 degrees to 180 degrees. The electronic device 200 may rotate about the hinge 240 such that the first housing 210 and the second housing 220 form an angle from 180 degrees to 360 degrees, for example.

The first housing 210 may include a first surface 210a and a second surface 210b. For example, the first surface 210a may be provided to face in a first direction (e.g., +Z1-axis direction). The first surface 210a may be, e.g., a surface on which at least a portion of the flexible display 230 is disposed. The first surface 210a may refer to, e.g., a virtual surface overlapping at least a portion of the flexible display 230. For example, the second surface 210b may be provided to face in a second direction (e.g., -Z1-axis direction). The second surface 210b may be, e.g., a surface on which the first rear cover 212 is disposed. The second surface 210b may be parallel to the first surface 210a. The second surface 210b may refer to a plane defined by, e.g., the first rear cover 212.

The second housing 220 may include a third surface 220a and a fourth surface 220b. For example, the third surface 220a may be provided to face in the first direction (e.g., +Z1-axis direction). The third surface 220a may be, e.g., a surface on which at least a portion of the flexible display 230 is disposed. The third surface 220a may refer to, e.g., a virtual surface overlapping at least a portion of the flexible display 230. For example, the fourth surface 220b may be provided to face in a second direction (e.g., -Z1-axis direction). The fourth surface 220b may be, e.g., a surface on which the second rear cover 222 is disposed. The fourth surface 220b may be parallel to the third surface 220a. The fourth surface 220b may refer to a plane defined by, e.g., the second rear cover 222.

In case that the electronic device 200 is unfolded, the first surface 210a and the third surface 220a may be positioned within one arbitrary virtual plane (e.g., an X1-Y1 plane). For example, the first surface 210a and the third surface 220a may form the same plane in case that the electronic device 200 is unfolded. For example, the first surface 210a and the third surface 220a may be disposed to form 180 degrees with respect to the X1-Y1 plane in the unfolded state. In case that the electronic device 200 is unfolded, the second surface 210b and the fourth surface 220b may be positioned within another arbitrary virtual plane (e.g., an X1-Y1 plane). For example, the second surface 210b and the fourth surface 220b may form the same plane in the unfolded state of the electronic device 200. For example, the second surface 210b and the fourth surface 220b may be disposed to form 180 degrees with respect to the X1-Y1 plane in the unfolded state.

In the folded state of the electronic device 200, at least a portion of the first surface 210a and at least a portion of the third surface 220a may face each other. For example, in the folded state of the electronic device 200, the angle between the first surface 210a and the third surface 220a may be 0 degrees from the X1-Y1 plane. As the electronic device 200 is folded from the unfolded state, the angle between the first surface 210a and the third surface 220a from the X1-Y1 plane may gradually decrease. For example, the angle formed between the first surface 210a and the third surface 220a from the X1-Y1 plane in the intermediate state may be determined between about 0 degrees and about 180 degrees. In the folded state of the electronic device 200, the second surface 210b and the fourth surface 220b may be parallel to each other. For example, the second surface 210b and the fourth surface 220b may face in opposite directions in the folded state of the electronic device 200.

The pair of housings 210 and 220 included in the electronic device 200 is not limited to the shape and coupling shown but may rather be implemented in other shapes or via a combination and/or coupling of other components.

The first housing 210 may include a first side frame 211. The first side frame 211 may constitute a side surface of the first housing 210. The first side frame 211 may form part of the exterior of the first housing 210. The first side frame 211 may be provided to protect components received inside the electronic device 200 from the outside.

The first side frame 211 may include a first side member 211a, a second side member 211b, and/or a third side member 211c. The first side member 211a may have a first length along a first length direction (e.g., Y1-axis direction). The second side member 211b may extend from the first side member 211a in a substantially vertical direction (e.g., the X1-axis direction). The second side member 211b may extend to have a second length equal to or different from the first length. The third side member 211c may extend from the second side member 211b in a substantially vertical direction (e.g., the Y1-axis direction). The third side member 211c may extend in a direction substantially parallel to the first side member 211a. The third side member 211c may have a first length along the first length direction (e.g., Y1-axis direction).

The first side member 211a, the second side member 211b, and the third side member 211c may be disposed to be visible from the outside. At least a portion of the first side member 211a, the second side member 211b, and/or the third side member 211c may be formed as a curved surface. The first side frame 211 may be formed in a rectangular (e.g., square or rectangular) shape by the first side member 211a, the second side member 211b, and the third side member 211c. The first side member 211a, the second side member 211b, and the third side member 211c may be integrally formed, but are not limited thereto.

The second housing 220 may include a second side frame 221. The second side frame 221 may constitute a side surface of the second housing 220. The second side frame 221 may form part of the exterior of the second housing 220. The second side frame 221 may be provided to protect components received inside the electronic device 200 from the outside.

The second side frame 221 may include a fourth side member 221a, a fifth side member 221b, and/or a sixth side member 221c. The fourth side member 221a may have a third length along a first length direction (e.g., Y1-axis direction). The fifth side member 221b may extend from the fourth side member 221a in a substantially vertical direction (e.g., the X1-axis direction). The fifth side member 221b may extend to have a fourth length equal to or different from the third length. The sixth side member 221c may extend from the fifth side member 221b in a substantially vertical direction (e.g., the Y1-axis direction). The sixth side member 221c may extend in a direction substantially parallel to the fourth side member 221a. The sixth side member 221c may have a third length along the first length direction (e.g., Y1-axis direction).

The fourth side member 221a, the fifth side member 221b, and the sixth side member 221c may be disposed to be visible from the outside. At least a portion of the fourth side member 221a, the fifth side member 221b, and/or the sixth side member 221c may be formed as a curved surface. The second side frame 221 may be formed in a rectangular (e.g., square or rectangular) shape by the fourth side member 221a, the fifth side member 221b, and the sixth side member 221c. The first length may be substantially equal to the third length. The second length may be substantially equal to the fourth length. The fourth side member 221a, the fifth side member 221b, and the sixth side member 221c may be integrally formed, but are not limited thereto.

In the unfolded state of the electronic device 200, the first side member 211a and the fourth side member 221a may be positioned substantially in a straight line. In the unfolded state of the electronic device 200, the second side member 211b and the fifth side member 221b may be parallel to each other. In the unfolded state of the electronic device 200, the third side member 211c and the sixth side member 221c may be positioned substantially in a straight line.

In the folded state of the electronic device 200, the first side member 211a and the fourth side member 221a may overlap each other. In the folded state of the electronic device 200, the second side member 211b and the fifth side member 221b may overlap each other. In the folded state of the electronic device 200, the third side member 211c and the sixth side member 221c may overlap each other.

The first housing 210 may include a first rear cover 212. The first rear cover 212 may form at least a portion of the second surface 210b of the first housing 210. The first rear cover 212 may be combined with the first side frame 211. The first rear cover 212 may be integrally formed with, e.g., the first side frame 211.

The second housing 220 may include a second rear cover 222. The second rear cover 222 may form at least a portion of the fourth surface 220b of the second housing 220. The second rear cover 222 may be combined with the second side frame 221. The second rear cover 222 may be integrally formed with, e.g., the second side frame 221.

The first rear cover 212 and/or the second rear cover 222 may be formed of at least one of, or a combination of at least two of, laminated or colored glass, ceramic, Glastic, polymer, or metal (e.g., aluminum, stainless steel (STS), or magnesium).

The electronic device 200 may include a flexible display 230 (e.g., a foldable display or display). The flexible display 230 may be disposed across the first housing 210, the hinge 240 and the second housing 220. The flexible display 230 may be disposed from the first surface 210a of the first housing 210 across the hinge 240 up to at least a portion of the third surface 220a of the second housing 220. The flexible display 230 may be disposed so that the first surface 210a of the first housing 210 and the third surface 220a of the second housing 220 overlap. A portion of the flexible display 230 corresponding to the hinge 240 may be bent according to the rotation of the hinge 240.

In the unfolding state, the flexible display 230 may be disposed to be visible from the outside. In a folding state, the flexible display 230 may be disposed to be invisible from the outside.

The electronic device 200 may include a protective cover 231. The protective cover 231 may be positioned to protect an edge portion of the flexible display 230. The protective cover 231 may form part of the exterior of the electronic device 200.

The electronic device 200 may include at least one of an input device (e.g., the microphone 203), a sound output device (e.g., the receiver 201 for phone calls or speaker 202), sensor modules 204, a camera module (the first camera module 205 or second camera module 208), a connector port 207, a key input device (not shown), or an indicator (not shown), disposed in the first inner space 214 of the first housing 210 or the second inner space 224 of the second housing 220. The electronic device 200 may be configured to omit at least one of the above-described components or add other components.

The input device may include a plurality of microphones disposed to detect the direction of sound. The sound output device may include, e.g., the receiver 201 for phone calls and the speaker 202. The sound output devices 201 and 202 may be disposed to face the outside through at least one speaker hole formed in the first housing 210 or the second housing 220. The connector port 207 may be disposed to face the outside through a connector port hole formed in the first housing 210 or the second housing 220.

The sensor module 204 may produce an electrical signal or data value corresponding to the internal operation state or external environment state of the electronic device 200. The sensor module 204 may include at least one of a proximity sensor, an illuminance sensor, a time of flight (TOF) sensor, an ultrasonic sensor, a fingerprint recognition sensor, a gesture sensor, a gyro sensor, an air pressure sensor, a magnetic sensor, an accelerometer, a grip sensor, a color sensor, an infrared (IR) sensor, a biometric sensor, a temperature sensor, or a humidity sensor.

The camera module may include a first camera module 205 disposed on the front (e.g., surface in the +Z1-axis direction) of the electronic device 200 or a second camera module 208 disposed on the rear surface (e.g., surface in the -Z1-axis direction) of the electronic device 200. The first camera module 205 and/or the second camera module 208 may include one or more lenses, an image sensor, and/or an image signal processor. For example, the first camera module 205 may be disposed under the flexible display 230 and be configured to capture a subject through a portion of the active area of the flexible display 230. The flash 209 may be disposed on the second camera module 208. The flash 209 may include, e.g., a light emitting diode (LED) or a xenon lamp.

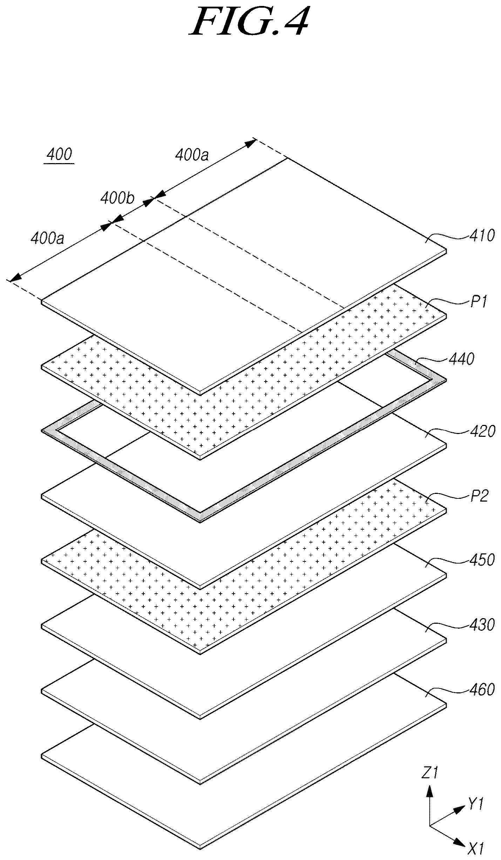

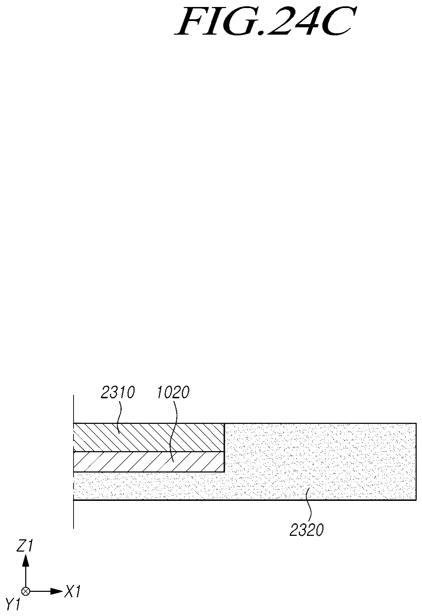

FIG. 4 is a perspective view illustrating a stacked structure of a flexible display according to an embodiment.

The flexible display 400 illustrated in FIG. 4 may be at least partially similar to a flexible display (e.g., the flexible display 230 of FIG. 2A) provided in the electronic device (e.g., the electronic device 200 of FIG. 2A) described above.

According to an embodiment, the electronic devices 200 having various form factors in which one housing (e.g., the first housing 210 of FIG. 2A) moves with respect to another housing (e.g., the second housing 220 of FIG. 2A) may include the flexible display 400 illustrated in FIG. 4.

According to an embodiment, the flexible display 400 may be disposed to traverse at least the first housing 210 and the second housing 220. Therefore, as the second housing 220 moves with respect to the first housing 210, at least a portion of the flexible display 400 may be bent.

According to an embodiment, the flexible display 400 may include a flexible region and a non-flexible region. The flexible region and the non-flexible region may be configured in various shapes and numbers according to the form factor of the electronic device 200 on which the flexible display 400 is mounted. The flexible region may refer to a region bent according to the electronic device 200. The non-flexible region may refer to a region other than the flexible region, a region that is not bent or maintains a flat surface.

Referring to FIG. 4, the flexible display 400 may include a protective member 410 (e.g., a protective film), a glass member 420, and a display panel 430. According to an embodiment, the flexible display 400 may be configured such that the protective member 410, the glass member 420, and the display panel 430 are sequentially stacked from above. Each component may be adhered by adhesive members P1, P2, but the disclosure is not limited thereto.

The adhesive members P1, P2 may include at least one of an optically clear adhesive (OCA) film, an optically clear resin (OCR), a pressure sensitive adhesive (PSA) film, a heat-reactive adhesive, a general adhesive, or a double-sided tape. The adhesive members P1, P2 include a light-curing adhesive material or a thermosetting adhesive material, and the material thereof is not particularly limited. The adhesive members P1, P2 may include, e.g., at least one of a first adhesive member P1 provided to adhere the protective member 410 and the glass member 420, and a second adhesive member P2 provided to adhere the glass member 420 and the display panel 430.

The first adhesive member P1 may be disposed to be attached to at least a portion of the upper surface of the glass member 420. The second adhesive member P2 may be disposed to be attached to at least a portion of the lower surface of the glass member 420. However, without limitation thereto, as is described below, the first adhesive member P1 may be attached to a portion of the upper surface of the glass member 420, and the second adhesive member P2 may be attached to the remaining portion of the upper surface of the glass member 420. Adhesive members having different physical properties may be provided around the glass member 420 in various ways and structures.

The configuration illustrated in FIG. 4 is for convenience of description, and the flexible display 400 may further include additional configurations. For example, although not illustrated, various types of layers such as a touch sensing layer may be provided above the display panel 430. The touch sensing layer may be configured to obtain coordinate information of an external input. The touch sensing layer may be, e.g., a capacitive touch sensing member. However, this is not limited thereto, and may be redisposed with other types of touch sensing layers including two types of touch electrodes, such as an electromagnetic induction method.

According to an embodiment, the display panel 430 may be disposed under the glass member 420. The display panel 430 may be disposed, e.g., below the glass member 420 with a polarizing layer 450 interposed therebetween. The display panel 430 may be an organic light emitting display panel, an electrophoretic display panel, an electrowetting display panel, or a quantum dot display panel, but the type is not limited. A light emitting layer of the organic light emitting display panel may include an organic light emitting material. A light emitting layer of the quantum dot display panel may include quantum dots and quantum rods. The display panel 430 may be formed such that at least a portion thereof is bendable. For example, the display panel 430 may be formed such that at least a portion thereof is deformable.

According to an embodiment, the flexible display 400 may include a polarizing layer 450. The polarizing layer 450 may be disposed on the display panel 430. For example, the polarizing layer 450 may be disposed between the glass member 420 and the display panel 430. The polarizing layer 450 may reduce the external light reflectance of the flexible display 400 by absorbing or destructively interfering light incident from outside. For example, the polarizing layer 450 may be integrally formed with the display panel 430 by a continuous process. For example, the polarizing layer 450 may be a component of the display panel 430. In case that the polarizing layer 450 and the display panel 430 are integrally formed, an adhesive member therebetween may be omitted. In case that the polarizing layer 450 is separately manufactured and attached to the display panel 430, it may be attached by an adhesive member.

According to an embodiment, the glass member 420 may be disposed above the display panel 430. The glass member 420 may be attached to directly contact the display panel 430 by an adhesive member. However, without limitation thereto, various types of layers such as the polarizing layer 450 or a touch sensing layer (not illustrated) may be provided between the glass member 420 and the display panel 430.

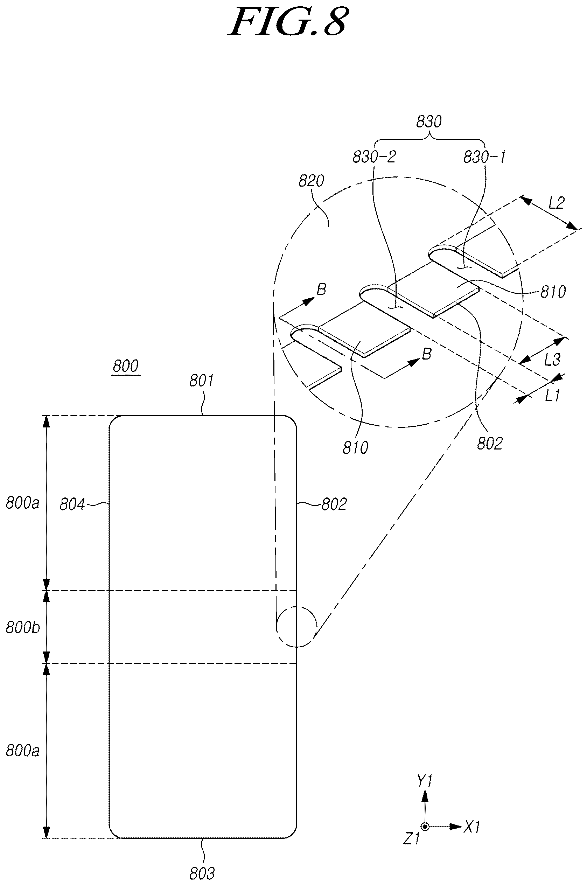

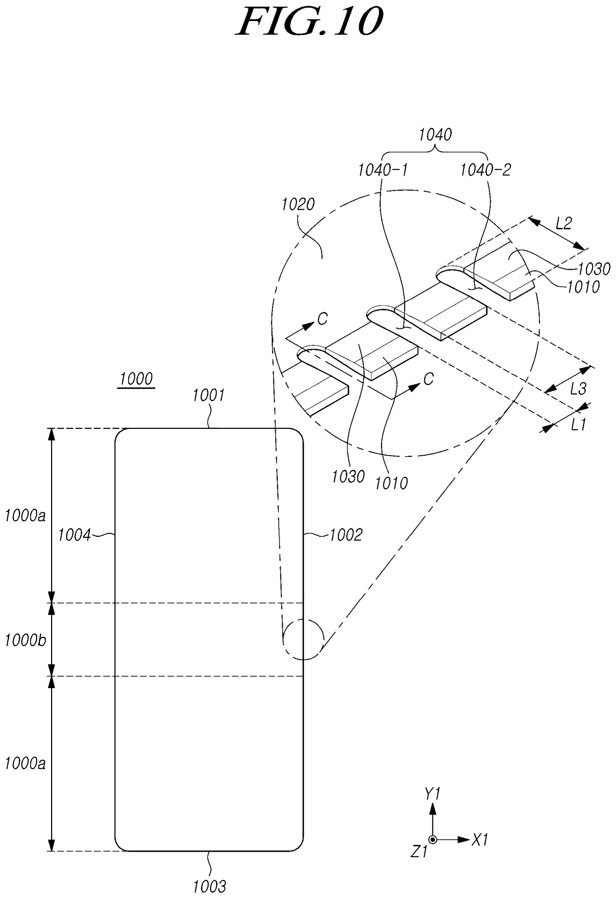

According to an embodiment, the glass member 420 may have various shapes to enhance rigidity of the edge portion in the flexible region 400b. The edge portion corresponding to the flexible region 400b among the edge portions of the glass member 420 may be formed with a plurality of recesses (e.g., the plurality of recesses 830 of FIG. 8 or the plurality of recesses 1040 of FIG. 10), or may be formed to have a thicker thickness compared to other portions. The glass member 420 may have various structures in the edge portion to prevent or reduce breakage in the flexible region 400b, and a detailed description is provided later.

According to an embodiment, the protective member 410 (e.g., a protective film) may be disposed on the uppermost layer of the flexible display 400. The protective member 410 may be disposed above the glass member 420 to protect the glass member 420 from external impact. The protective member 410 may protect the glass member 420 from external impact and help prevent or reduce scattering of glass fragments in case that the glass member 420 breaks.

The protective member 410 and the glass member 420 may be adhered by the first adhesive member P1. As the protective member 410 and the glass member 420 are adhered to each other, the first adhesive member P1 may be disposed between the protective member 410 and the glass member 420.

According to an embodiment, the protective member 410 may be attached to the glass member 420 in a separable manner. In case that the protective member 410 is damaged by external impact, a new protective member 410 may be attached onto the glass member 420. Therefore, the adhesive force of the first adhesive member P1 may be weaker than the adhesive force of the second adhesive member P2.

According to an embodiment, the protective member 410 may include polyethylene terephthalate (PET) or polyimide (PI), but is not limited thereto and may include materials used for the glass member 420 or a polymer member 460 to be described below. For example, the thickness of the protective member 410 may be substantially the same as or relatively thinner than the thickness of the glass member 420. As an example, the protective member 410 may be omitted from the configuration of the flexible display 400. In case that the protective member 410 is omitted, the first adhesive member P1 may also be omitted.

According to an embodiment, the flexible display 400 may include a polymer member 460 disposed below the display panel 430. The polymer member 460 may, e.g., have a dark color applied to help display the background in case that the display is off. The polymer member 460 may, e.g., act as a cushioning member to absorb impact from outside of the electronic device to prevent or reduce breakage of the flexible display 400.

The polymer member 460 may include a plastic film as a base layer. The polymer member may include a plastic film including any one selected from the group consisting of polyethersulphone (PES), polyacrylate (PAR), polyetherimide (PEI), polyethylene naphthalate (PEN), polyethylene terephthalate (PET), polyphenylene sulphide (PPS), polyarylate, polyimide (PI), polycarbonate (PC), or combinations thereof.

Although not illustrated, a metal sheet layer may be disposed under the display panel 430. The metal sheet layer may help reinforce the rigidity of the electronic device. The metal sheet layer may be used, e.g., to shield ambient noise and disperse heat emitted from surrounding heat-emitting components. The metal sheet layer may include at least one of stainless steel (STS), Cu, Al, or other alloy materials.

According to an embodiment, the flexible display 400 may further include a printing layer 440. The printing layer 440 may be disposed in a partial area of the flexible display 400. For example, the printing layer 440 may be disposed near the edge of the protective member 410. For example, the printing layer 440 may be disposed along the edge of the protective member 410. As an example, the printing layer 440 may extend along the edge of the protective member 410 to have a substantially rectangular shape. For example, the printing layer 440 may be disposed along the rim of the protective member 410. The printing layer 440 may be disposed on the upper surface or lower surface of the protective member 410. However, without limitation thereto, the printing layer 440 may also be disposed on the upper surface or lower surface of the glass member 420.

However, without limitation thereto, the printing layer 440 may also be disposed along the edge of the glass member 420, unlike what is illustrated. For example, the printing layer 440 may also be disposed on the upper surface or lower surface of the glass member 420.

According to an embodiment, the printing layer 440 may be a border (e.g., black matrix (BM) printing layer) of the display area visible from outside in a state in which the flexible display 400 is disposed in an electronic device (e.g., the electronic device 200 of FIG. 2A). The printing layer 440 may be formed along the periphery portion of the protective member 410, but the disclosure is not limited thereto. For example, the printed layer 440 may form a bezel pattern. The printed layer 440 may include, e.g., a light-blocking material through which light does not transmit.

The printed layer 440 may have a width of, e.g., 2.5 mm or less, but the disclosure is not limited thereto.

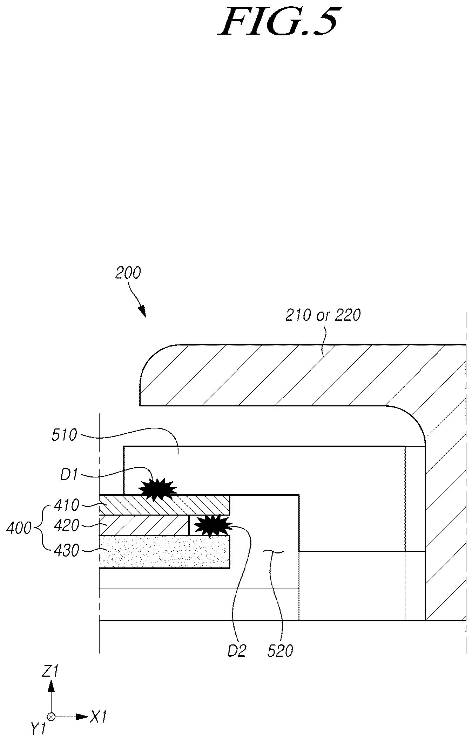

FIG. 5 is a cross-sectional view taken along the periphery portion of an electronic device according to an embodiment.

The structure illustrated in FIG. 5 is schematic for describing a foreign objects intrusion structure, and the disclosure is not limited thereto. The structure illustrated in FIG. 5 is schematically illustrated for convenience of description, and the shape of FIG. 5 does not limit the scope of rights of the disclosure.

Referring to FIG. 5, an electronic device 200 may include a flexible display 400, a protective cap 510, and a housing 210 or 220.

According to an embodiment, the protective cap 510 may be disposed between the flexible display 400 and the housing 210 or 220 to prevent or reduce foreign objects from entering between the flexible display 400 and the housing 210 or 220. The protective cap 510 may be disposed to contact the edge portion of the flexible display 400. The protective cap 510 may be, e.g., formed of rubber material, but the disclosure is not limited thereto.

A step may be formed on the side of the flexible display 400 due to size differences of each component. As an example, the side of the glass member 420 may be positioned inward between the protective member 410 and the display panel 430, forming a concave space.

Foreign objects may enter between the flexible display 400 and the protective cap 510 while using the electronic device 200. In particular, in a bent state of the electronic device 200, a minute gap is formed between the protective cap 510 and the flexible display 400, and foreign objects may enter through such a gap.

Foreign objects entering between the flexible display 400 and the protective cap 510 may break the glass member 420.

As an example, in case that foreign objects are located at the first position D1 as illustrated, the glass member 420 may be broken. Here, the first position D1 may refer to a space between the protective member 410 and the protective cap 510. In case that foreign objects are located at the first position D1, if a force pressing the protective cap 510 from above is applied, the glass member 420 may be broken by stress applied to the foreign objects. For example, foreign objects positioned at the first position by folding and/or unfolding operations of an electronic device (e.g., the electronic device 200 of FIG. 2A) may receive a pressing load in the direction toward the flexible display 400 by being pressed by the protective cap 510. This may cause breakage starting from the protective member 410 in contact with the foreign objects, and furthermore, high stress may be transmitted to the glass member 420, breaking the glass member 420 and the display panel 430.

As an example, in case that foreign objects are located at the second position D2 as illustrated, the glass member 420 may be broken. The second position D2 may refer to a position adjacent to the glass member 420 among the empty space between the side of the flexible display 400 and the housing 210 or 220. Foreign objects located at the second position D2 may cause small cracks on the side of the glass member 420 by directly contacting the side of the glass member 420. Such small cracks may grow due to stress formed according to folding operations of an electronic device (e.g., the electronic device 200 of FIG. 2A) or external impact, ultimately breaking the glass member 420.

The disclosure proposes structures of the glass member 420 according to various embodiments, thereby reducing breakage of the glass member 420. A detailed description of the glass member 420 according to various embodiments is provided later.

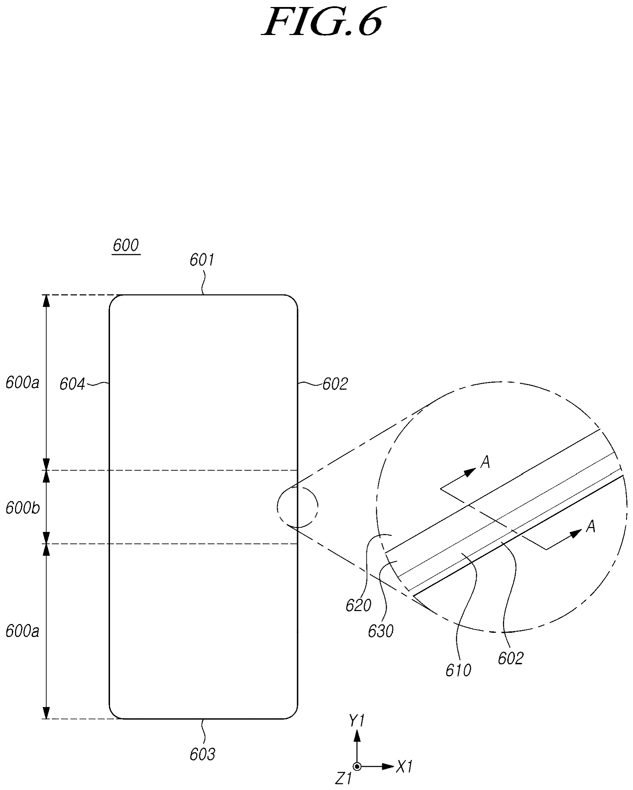

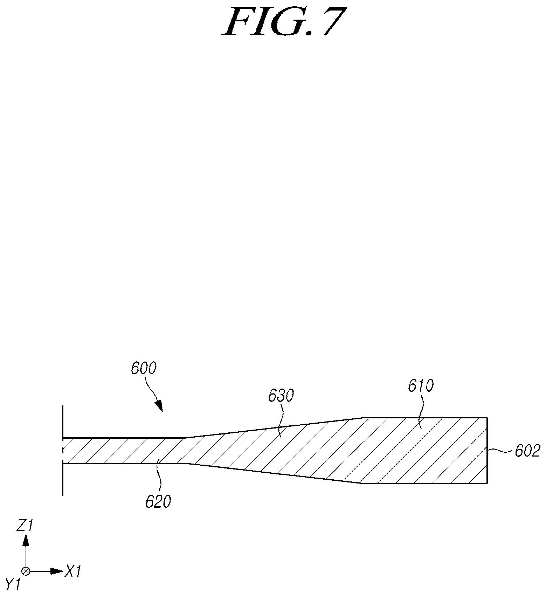

FIG. 6 is a view illustrating a glass member according to an embodiment. FIG. 7 is a cross-sectional view taken along line A-A of FIG. 6.

The glass member 600 illustrated in FIGS. 6 and 7 may be included in the flexible display illustrated in FIG. 4 (e.g., the flexible display 400 of FIG. 4). The glass member 600 illustrated in FIGS. 6 and 7 may be substantially the same or similar configuration as the glass member illustrated in FIG. 4 (e.g., the glass member 420 of FIG. 4). Alternatively, the glass member 600 illustrated in FIGS. 6 and 7 may replace the glass member (e.g., the glass member 420 of FIG. 4) in the flexible display illustrated in FIG. 4 (e.g., the flexible display 400 of FIG. 4).

In FIG. 7, the thickness of the glass member 600 may be illustrated somewhat exaggerated for convenience of description.

The embodiments of FIGS. 6 and 7 may be selectively combined with the embodiments of FIGS. 1 to 4. The embodiments of FIGS. 6 and 7 may be selectively combined with the embodiments of FIGS. 8 to 33C.

Referring to FIGS. 6 and 7, the glass member 600 may be configured such that at least a portion thereof is deformable. For example, the glass member 600 may include a non-flexible region 600a and a flexible region 600b. Here, the non-flexible region 600a of the glass member 600 may correspond to the non-flexible region of FIG. 4 (e.g., the non-flexible region 400a of FIG. 4). Here, the flexible region 600b of the glass member 600 may correspond to the flexible region of FIG. 4 (e.g., the flexible region 400b of FIG. 4).

According to an embodiment, the glass member 600 may include a first side surface 601, a second side surface 602 extending perpendicularly from the first side surface 601, a third side surface 603 extending perpendicularly from the second side surface 602 and parallel to the first side surface 601, and a fourth side surface 604 extending perpendicularly from the third side surface 603 and parallel to the second side surface 602.

According to an embodiment, the glass member 600 may include a first glass portion 610 and a second glass portion 620.

According to an embodiment, the first glass portion 610 may include a portion adjacent from the edge of the glass member 600. The first glass portion 610 may include an area within a predetermined distance from the edge of the glass member 600. For example, the first glass portion 610 may include an area within a predetermined distance from the edge of the glass member 600 included in the flexible region 600b within the flexible region 600b. For example, the first glass portion 610 may include an area within a predetermined interval from the edge portion corresponding to the flexible region 600b among the edges of the glass member 600. For example, the first glass portion 610 may include an area within a predetermined interval from a portion of the side surface (e.g., the second side surface 602 or the fourth side surface 604) of the glass member 600. Here, the predetermined interval may be 1 mm or less, but the disclosure is not limited thereto.

According to an embodiment, in case that the glass member 600 is included in the flexible display 400 of FIG. 4, the first glass portion 610 may be positioned where it overlaps a portion of the printing layer (e.g., the printing layer 440 of FIG. 4). The first glass portion 610 may be positioned to be visually hidden by the printing layer 440.

According to an embodiment, the first glass portion 610 may have a vertically symmetrical structure. However, it is not limited thereto and may have a shape protruding further to at least one of the upper or lower sides. According to an embodiment, the first glass portion 610 may have a shape protruding to at least one of the upper or lower sides. For example, one of the upper or lower sides may have a non-protruding shape.

According to an embodiment, the second glass portion 620 may be a portion different from the first glass portion 610. The second glass portion 620 may include at least a portion of the glass member 600 other than the first glass portion 610.

According to an embodiment, the thickness of the first glass portion 610 may be formed relatively thicker than the thickness of the second glass portion 620. For example, the thickness of the first glass portion 610 may be thicker than the average thickness of the glass member 600. The rigidity of the first glass portion 610 may be relatively stronger than the rigidity of the second glass portion 620. The thickness difference between the first glass portion 610 and the second glass portion 620 may be formed by an etching process using chemicals, but the manufacturing method is not limited thereto.

According to an embodiment, the first glass portion 610 may be positioned where it overlaps at least a portion of the area where the protective cap (e.g., the protective cap 510 of FIG. 5) and the protective member (e.g., the protective member 410 of FIG. 5) illustrated in FIG. 5 contact. By forming the first glass portion 610 relatively thicker than the second glass portion 620, even in case that foreign objects get stuck in the first position of FIG. 5 (e.g., the first position D1 of FIG. 5), breakage caused by foreign objects may be efficiently prevented or decreased.

According to an embodiment, the glass member 600 may include a third glass portion 630. The third glass portion 630 may be positioned between the first glass portion 610 and the second glass portion 620. The third glass portion 630 may be a portion connecting the first glass portion 610 and the second glass portion 620.

The third glass portion 630 may be formed to be inclined upward from the second glass portion 620 toward the first glass portion 610. The third glass portion 630 may be formed to be inclined downward from the first glass portion 610 toward the second glass portion 620. However, without limitation thereto, unlike what is illustrated, the third glass portion 630 may form a step according to the thickness difference between the first glass portion 610 and the second glass portion 620.

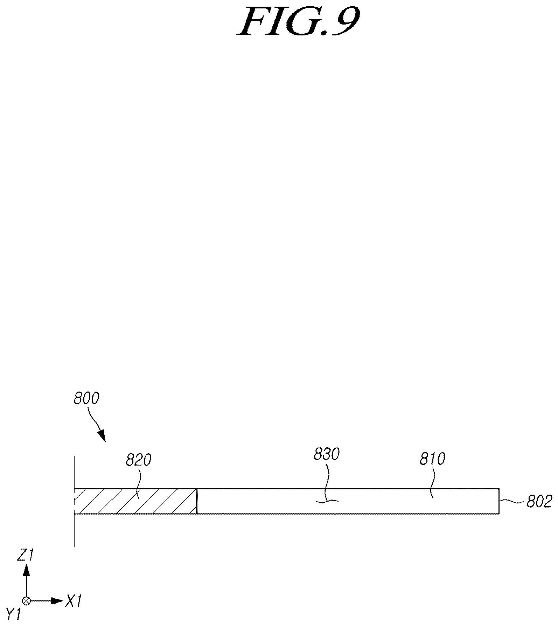

FIG. 8 is a view illustrating a glass member according to an embodiment. FIG. 9 is a cross-sectional view taken along line B-B of FIG. 8.

The glass member 800 illustrated in FIGS. 8 and 9 may be included in the flexible display illustrated in FIG. 4 (e.g., the flexible display 400 of FIG. 4). The glass member 800 illustrated in FIGS. 8 and 9 may be substantially the same or similar configuration as the glass member illustrated in FIG. 4 (e.g., the glass member 420 of FIG. 4). Alternatively, the glass member 800 illustrated in FIGS. 8 and 9 may replace the glass member (e.g., the glass member 420 of FIG. 4) in the flexible display illustrated in FIG. 4 (e.g., the flexible display 400 of FIG. 4).

In FIG. 9, the thickness of the glass member 800 may be illustrated somewhat exaggerated for convenience of description.

The embodiments of FIGS. 8 and 9 may be selectively combined with the embodiments of FIGS. 1 to 7. The embodiments of FIGS. 8 and 9 may be selectively combined with the embodiments of FIGS. 10 to 33C.

Referring to FIGS. 8 and 9, the glass member 800 may be configured such that at least a portion thereof is deformable. For example, the glass member 800 may include a non-flexible region 800a and a flexible region 800b. Here, the non-flexible region 800a of the glass member 800 may correspond to the non-flexible region of FIG. 4 (e.g., the non-flexible region 400a of FIG. 4). Here, the flexible region 800b of the glass member 800 may correspond to the flexible region of FIG. 4 (e.g., the flexible region 400b of FIG. 4).

According to an embodiment, the glass member 800 may include a first side surface 801, a second side surface 802 extending perpendicularly from the first side surface 801, a third side surface 803 extending perpendicularly from the second side surface 802 and parallel to the first side surface 801, and a fourth side surface 804 extending perpendicularly from the third side surface 803 and parallel to the second side surface 802.

According to an embodiment, the glass member 800 may include a first glass portion 810 and a second glass portion 820.

According to an embodiment, the first glass portion 810 may include a portion adjacent from the edge of the glass member 800. The first glass portion 810 may include an area within a predetermined distance from the edge of the glass member 800. For example, the first glass portion 810 may include an area within a predetermined distance from the edge of the glass member 800 included in the flexible region 800b in the flexible region 800b. For example, the first glass portion 810 may include an area within a predetermined interval from the edge portion corresponding to the flexible region 800b among the edges of the glass member 800. For example, the first glass portion 810 may include an area within a predetermined interval from a portion of the side surface (e.g., the second side surface 802 or the fourth side surface 804) of the glass member 800. Here, the predetermined interval may be 1 mm or less, but the disclosure is not limited thereto.

In case that the glass member 800 is included in the flexible display 400 of FIG. 4, the first glass portion 810 may be positioned where it overlaps a portion of the printing layer (e.g., the printing layer 440 of FIG. 4). The first glass portion 810 may be positioned to be visually hidden by the printing layer 440.

The second glass portion 820 may be a portion different from the first glass portion 810. The second glass portion 820 may include at least a portion of the glass member 800 other than the first glass portion 810.

According to an embodiment, the glass member 800 may include a plurality of recesses 830. The plurality of recesses 830 may be formed to be recessed inward from the edge or side surface of the glass member 800. For example, the plurality of recesses 830 may be formed inwardly from the outside (or from the edge) of the glass member 800 on at least one side surface of the glass member 800. The plurality of recesses 830 may be formed near the edge corresponding to the flexible region 800b of the glass member 800. For example, the plurality of recesses 830 may be formed to be recessed inward from the edge or side surface corresponding to the flexible region 800b. The plurality of recesses 830 may be formed to penetrate vertically through the glass member 800, but the disclosure is not limited thereto. The plurality of recesses 830 may be disposed adjacent to the first glass portion 810. The plurality of recesses 830 may be formed by a physical processing method, laser processing method, or chemical etching method, but the disclosure is not limited thereto.

According to an embodiment, the plurality of recesses 830 may be formed around the first glass portion 810. For example, the first glass portion 810 may have a comb-like shape due to the plurality of recesses 830, but the disclosure is not limited thereto. For example, the first glass portion 810 may be disposed between two adjacent recesses 830.

According to an embodiment, the plurality of recesses 830 may be disposed to be spaced apart at predetermined intervals. For example, the plurality of recesses 830 may be disposed to be spaced apart at predetermined intervals along the length direction of the glass member 800. Here, the length direction of the glass member 800 may refer to the length direction of the second side surface 802. Here, the predetermined interval may be within 1 micrometer to 1 millimeter, but the disclosure is not limited thereto. For example, the depth L2 of the plurality of recesses 830 may be within 1 micrometer to 1 millimeter, but the disclosure is not limited thereto. For example, the width L1 of the plurality of recesses 830 may be within 1 micrometer to 1 millimeter, but the disclosure is not limited thereto.

According to an embodiment, the plurality of recesses 830 may include a first recess 830-1 and a second recess 830-2. The first recess 830-1 and the second recess 830-2 may be disposed adjacent to each other. The first recess 830-1 and the second recess 830-2 may be disposed to be spaced apart with the first glass portion 810 therebetween. The first recess 830-1 and the second recess 830-2 may be substantially the same in size or shape, but the disclosure is not limited thereto.

Since each of the plurality of recesses 830 is formed with a small size within 1 millimeter, direct impact to the display panel (e.g., the display panel 430 of FIG. 4) by the plurality of recesses 830 may be prevented or decreased. For example, even in case that force is applied to the first glass portion 810 side in the flexible display (e.g., the flexible display 400 of FIG. 4), force is not directly applied from the protective member (e.g., the protective member 410 of FIG. 4) to the display panel (e.g., the display panel 430 of FIG. 4), and the first glass portion 810 having an about comb shape may protect the display panel 430.

According to an embodiment, the spacing L3 between the plurality of recesses 830 may vary even within the flexible region 800b. According to an embodiment, the spacing between the plurality of recesses 830 may become smaller as it approaches the center of the flexible region 800b (e.g., the folding axis F of FIG. 3).

According to an embodiment, as the first glass portion 810 of the glass member 800 has an about comb-like shape due to the plurality of recesses 830, breakage of the glass member 800 due to foreign objects intrusion may be prevented or decreased. For example, even in case that foreign objects enter the second position of FIG. 5 (e.g., the second position D2 of FIG. 5), by reducing the side surface area of the first glass portion 810, the probability of foreign objects contacting the side surface of the glass member 800 may be decreased.

Even in case that foreign objects contact the first glass portion 810 of the glass member 800 and cracks occur on the side surface of the first glass portion 810, the structural features of the about comb shape may prevent or reduce the expansion of cracks to the entire area of the glass member 800. Even in case that the flexible region 800b of the glass member 800 is bent, stress applied to the first glass portion 810 may be relatively decreased by the first glass portion 810 having an about comb shape. In other words, since the stress applied during bending to the first glass portion 810 formed with the plurality of recesses 830 is relatively smaller compared to glass without the plurality of recesses 830 formed, crack expansion may be prevented or decreased.

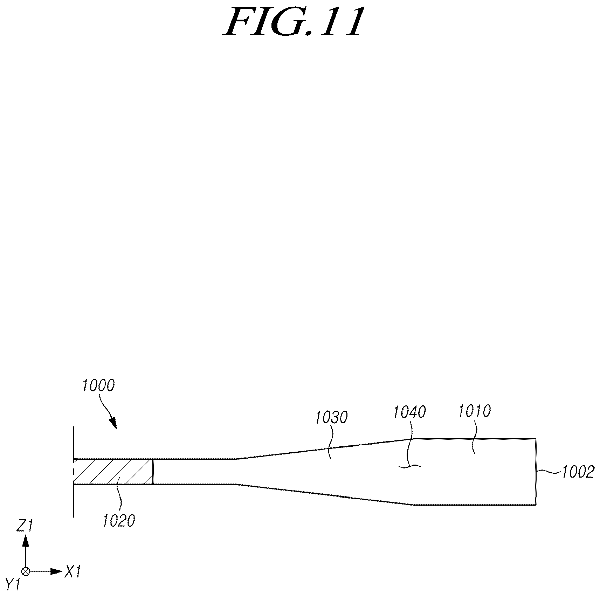

FIG. 10 is a view illustrating a glass member according to an embodiment. FIG. 11 is a cross-sectional view taken along line C-C of FIG. 10.

The glass member 1000 illustrated in FIGS. 10 and 11 may be included in the flexible display illustrated in FIG. 4 (e.g., the flexible display 400 of FIG. 4). The glass member 1000 illustrated in FIGS. 10 and 11 may be substantially the same or similar configuration as the glass member illustrated in FIG. 4 (e.g., the glass member 420 of FIG. 4). Alternatively, the glass member 1000 illustrated in FIGS. 10 and 11 may replace the glass member (e.g., the glass member 420 of FIG. 4) in the flexible display illustrated in FIG. 4 (e.g., the flexible display 400 of FIG. 4).

In FIG. 11, the thickness of the glass member 1000 may be illustrated somewhat exaggerated for convenience of description.

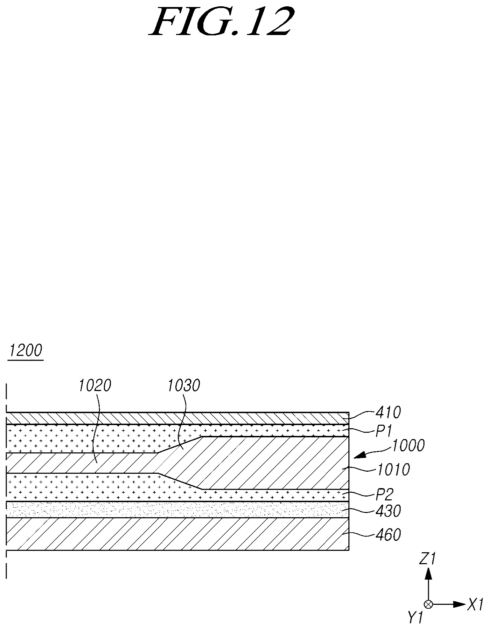

The embodiments of FIGS. 10 and 11 may be selectively combined with the embodiments of FIGS. 1 to 9. The embodiments of FIGS. 10 and 11 may be selectively combined with the embodiments of FIGS. 12 to 33C.

Referring to FIGS. 10 and 11, the glass member 1000 may be configured such that at least a portion thereof is deformable. For example, the glass member 1000 may include a non-flexible region 1000a and a flexible region 1000b. Here, the non-flexible region 1000a of the glass member 1000 may correspond to the non-flexible region of FIG. 4 (e.g., the non-flexible region 400a of FIG. 4). Here, the flexible region 1000b of the glass member 1000 may correspond to the flexible region of FIG. 4 (e.g., the flexible region 400b of FIG. 4).

According to an embodiment, the glass member 1000 may include a first side surface 1001, a second side surface 1002 extending perpendicularly from the first side surface 1001, a third side surface 1003 extending perpendicularly from the second side surface 1002 and parallel to the first side surface 1001, and a fourth side surface 1004 extending perpendicularly from the third side surface 1003 and parallel to the second side surface 1002.

According to an embodiment, the glass member 1000 may include a first glass portion 1010 and a second glass portion 1020.

According to an embodiment, the first glass portion 1010 may include a portion adjacent from the edge of the glass member 1000. The first glass portion 1010 may include an area within a predetermined distance from the edge of the glass member 1000. For example, the first glass portion 1010 may include an area within a predetermined distance from the edge of the glass member 1000 included in the flexible region 1000b in the flexible region 1000b. For example, the first glass portion 1010 may include an area within a predetermined interval from the edge portion corresponding to the flexible region 1000b among the edges of the glass member 1000. For example, the first glass portion 1010 may include an area within a predetermined interval from a portion of the side surface (e.g., the second side surface 1002 or the fourth side surface 1004) of the glass member 1000. Here, the predetermined interval may be 1 mm or less, but the disclosure is not limited thereto.

In case that the glass member 1000 is included in the flexible display 400 of FIG. 4, the first glass portion 1010 may be positioned where it overlaps a portion of the printing layer (e.g., the printing layer 440 of FIG. 4). The first glass portion 1010 may be positioned to be visually hidden by the printing layer 440.

According to an embodiment, the first glass portion 1010 may have a vertically symmetrical structure. However, it is not limited thereto and may have a shape protruding further to at least one of the upper or lower sides. According to an embodiment, the first glass portion 1010 may have a shape protruding to at least one of the upper or lower sides. For example, one of the upper or lower sides may have a non-protruding shape.

The second glass portion 1020 may be a portion different from the first glass portion 1010. The second glass portion 1020 may include at least a portion of the glass member 1000 other than the first glass portion 1010.

According to an embodiment, the thickness of the first glass portion 1010 may be formed relatively thicker than the thickness of the second glass portion 1020. For example, the thickness of the first glass portion 1010 may be thicker than the average thickness of the glass member 1000. The rigidity of the first glass portion 1010 may be relatively stronger than the rigidity of the second glass portion 1020. The thickness difference between the first glass portion 1010 and the second glass portion 1020 may be formed by an etching process using chemicals, but the manufacturing method is not limited thereto.

According to an embodiment, the first glass portion 1010 may be positioned where it overlaps at least a portion of the area where the protective cap (e.g., the protective cap 510 of FIG. 5) and the protective member (e.g., the protective member 410 of FIG. 5) illustrated in FIG. 5 contact. By forming the first glass portion 1010 relatively thicker than the second glass portion 1020, even in case that foreign objects gets stuck in the first position of FIG. 5 (e.g., the first position D1 of FIG. 5), breakage caused by foreign objects may be efficiently prevented or decreased.

According to an embodiment, the glass member 1000 may include a plurality of recesses 1040. The plurality of recesses 1040 may be formed to be recessed inward from the edge or side surface of the glass member 1000. For example, the plurality of recesses 1040 may be formed inwardly from the outside (or from the edge) of the glass member 1000 on at least one side surface of the glass member 1000. The plurality of recesses 1040 may be formed near the edge corresponding to the flexible region 1000b of the glass member 1000. For example, the plurality of recesses 1040 may be formed to be recessed inward from the edge or side surface corresponding to the flexible region 1000b. The plurality of recesses 1040 may be disposed adjacent to the first glass portion 1010. The plurality of recesses 1040 may be formed by a physical processing method, laser processing method, or chemical etching method, but the disclosure is not limited thereto.

According to an embodiment, the plurality of recesses 1040 may be formed around the first glass portion 1010. For example, the first glass portion 1010 may have a comb-like shape due to the plurality of recesses 1040, but the disclosure is not limited thereto.

According to an embodiment, the plurality of recesses 1040 may be disposed to be spaced apart at predetermined intervals. For example, the plurality of recesses 1040 may be disposed to be spaced apart at predetermined intervals along the length direction of the glass member 1000. Here, the length direction of the glass member 1000 may refer to the length direction of the second side surface 1002. Here, the predetermined interval may be within 1 micrometer to 1 millimeter, but the disclosure is not limited thereto. For example, the depth L2 of the plurality of recesses 1040 may be within 1 micrometer to 1 millimeter, but the disclosure is not limited thereto. For example, the width L1 of the plurality of recesses 1040 may be within 1 micrometer to 1 millimeter, but the disclosure is not limited thereto.

According to an embodiment, the plurality of recesses 1040 may include a first recess 1040-1 and a second recess 1040-2. The first recess 1040-1 and the second recess 1040-2 may be disposed adjacent to each other. The first recess 1040-1 and the second recess 1040-2 may be disposed to be spaced apart with the first glass portion 1010 therebetween. The first recess 1040-1 and the second recess 1040-2 may be substantially the same in size or shape, but the disclosure is not limited thereto.

Since each of the plurality of recesses 1040 is formed with a small size within 1 millimeter, direct impact to the display panel 430 by the plurality of recesses 1040 may be prevented or decreased. For example, even in case that force is applied to the first glass portion 1010 side in the flexible display (e.g., the flexible display 400 of FIG. 4), force is not directly applied from the protective member (e.g., the protective member 410 of FIG. 4) to the display panel (e.g., the display panel 430 of FIG. 4), and the first glass portion 1010 having an about comb shape may protect the display panel 430.

According to an embodiment, the spacing L3 between the plurality of recesses 1040 may vary even within the flexible region 1000b. According to an embodiment, the spacing between the plurality of recesses 1040 may become smaller as it approaches the center of the flexible region 1000b (e.g., the folding axis F of FIG. 3).

According to an embodiment, as the first glass portion 1010 of the glass member 1000 has an about comb-like shape due to the plurality of recesses 1040, breakage of the glass member 1000 due to foreign objects intrusion may be prevented or decreased. For example, even in case that foreign objects enter the second position of FIG. 5 (e.g., the second position D2 of FIG. 5), by reducing the side surface area of the first glass portion 1010, the probability of foreign objects contacting the side surface of the glass member 1000 may be decreased.

Even in case that foreign objects contact the first glass portion 1010 of the glass member 1000 and cracks occur on the side surface of the first glass portion 1010, the structural features of the about comb shape may prevent the expansion of cracks to the entire area of the glass member 1000. Even in case that the flexible region 1000b of the glass member 1000 is bent, stress applied to the first glass portion 1010 may be relatively decreased by the first glass portion 1010 having an about comb shape. In other words, since the stress applied during bending to the first glass portion 1010 formed with the plurality of recesses 1040 is relatively smaller compared to glass without the plurality of recesses 1040 formed, crack expansion may be prevented or decreased.

According to an embodiment, the glass member 1000 may include a third glass portion 1030. The third glass portion 1030 may be positioned between the first glass portion 1010 and the second glass portion 1020. The third glass portion 1030 may be a portion connecting the first glass portion 1010 and the second glass portion 1020.

The third glass portion 1030 may be formed to be inclined from the second glass portion 1020 toward the first glass portion 1010. The third glass portion 1030 may be formed to be inclined downward from the first glass portion 1010 toward the second glass portion 1020. However, without limitation thereto, unlike what is illustrated, the third glass portion 1030 may form a step according to the thickness difference between the first glass portion 1010 and the second glass portion 1020.

FIG. 12 is a cross-sectional view illustrating a flexible display according to an embodiment.

FIG. 12 illustrates a partial cross-sectional view illustrating the flexible display 1200 including the glass member 1000 illustrated in FIGS. 10 and 11. Hereinafter, the same reference numbers are used for configurations that are substantially the same as the configurations described with reference to FIG. 4 among the configurations around the glass member 1000.

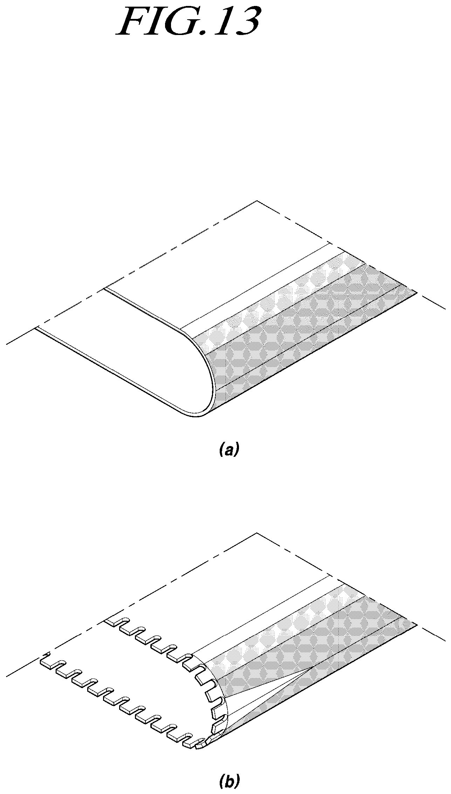

The embodiment of FIG. 12 may be selectively combined with the embodiment of FIGS. 1 to 11. The embodiment of FIG. 12 may be selectively combined with the embodiments of FIGS. 13 to 33C.

Referring to FIG. 12, a protective member 410 may be attached or bonded to the upper surface of the glass member 1000. The glass member 1000 may be attached or bonded to the protective member 410 by the first adhesive member P1. The thickness of the portion of the first adhesive member P1 in contact with the first glass portion 1010 may be thinner than the thickness of the portion of the first adhesive member P1 in contact with the second glass portion 1020.

A display panel 430 or a polarizing layer (e.g., the polarizing layer 450 of FIG. 4) may be attached or bonded to the lower surface of the glass member 1000. The glass member 1000 may be attached or bonded to the display panel 430 by the second adhesive member P2. The thickness of the portion of the second adhesive member P2 in contact with the first glass portion 1010 may be thinner than the thickness of the portion of the second adhesive member P2 in contact with the second glass portion 1020.

FIG. 13 is a view illustrating the magnitude of stress applied during bending of a flexible display according to an embodiment.

FIG. 13(a) is a view in which a plurality of recesses are not formed on the edge of the glass member. FIG. 13(b) is a view in which a plurality of recesses are formed on the edge of the glass member. FIG. 13(b) may be a view illustrating stress values for bending of the glass member of FIG. 8 (e.g., the glass member 800 of FIG. 8) or the glass member of FIG. 10 (e.g., the glass member 1000 of FIG. 10). The glass member illustrated in FIG. 13(a) and the glass member illustrated in FIG. 13(b) may be substantially the same in portions other than the formation of the plurality of recesses.

In FIGS. 13(a) and 13(b), the shading is illustrated darker as the bending stress becomes stronger during bending.

Comparing FIGS. 13(a) and 13(b), the difference in the magnitude of stress applied to the edge (or corner) during bending of the glass member may be identified. In case that a plurality of recesses are formed, the magnitude of stress applied to the edge portion of the glass member may be decreased. Therefore, as described with reference to FIG. 5, even in case that foreign objects enter the second position D2 and causes cracks on the edge of the glass member 1000, the stress applied during bending becomes smaller, preventing or reducing the expansion of cracks.

As an example, in the case of FIG. 13(a), the maximum stress applied to the edge may be 655.2 MPa. As an example, in the case of FIG. 13(b), the maximum stress applied to the edge may be 510.2 MPa. By forming a plurality of recesses, it may be identified that the magnitude of the maximum stress applied to the edge during bending of the glass member is decreased by about 22%.

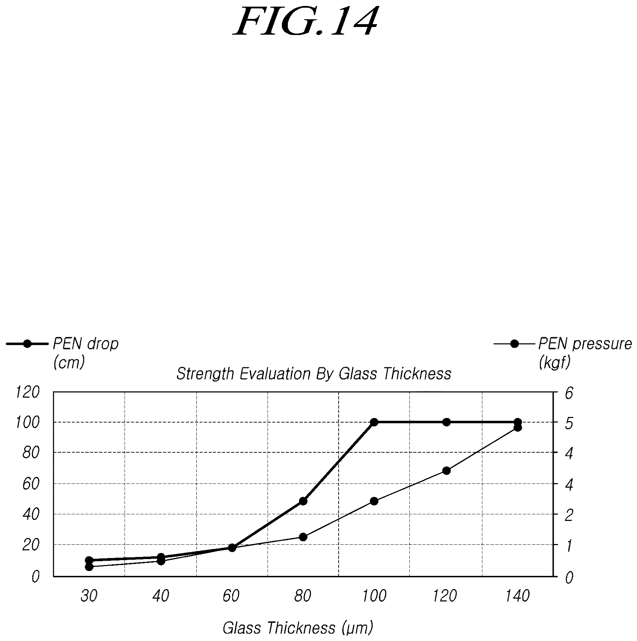

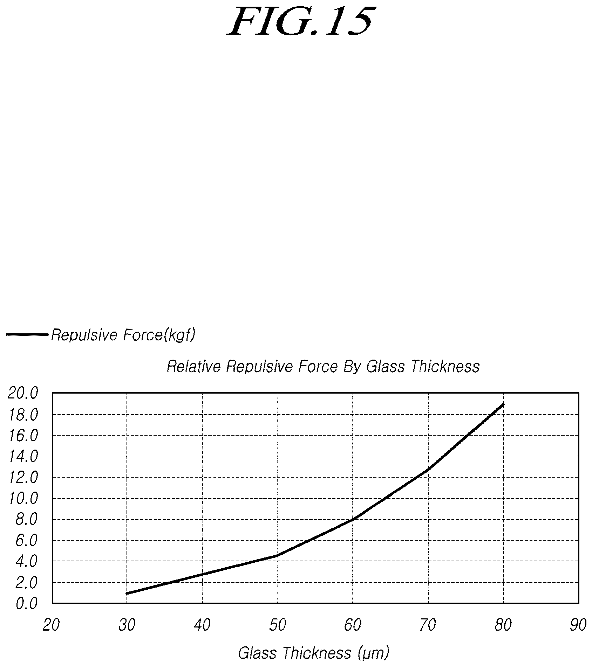

FIG. 14 is a graph illustrating strength according to thickness of a glass member according to an embodiment. FIG. 15 is a graph illustrating relative repulsive force according to thickness of a glass member according to an embodiment.

Referring to FIG. 14, it may be identified that as the thickness of the glass member increases, the strength of the glass member is generally strengthened. Here, PEN drop may refer to the height where breakage occurs in case that a pen is dropped from a predetermined distance above. Here, PEN pressure is a force pressing the glass member using PEN, and the value of PEN pressure may increase as the strength of the glass member is stronger. It may be identified that as the thickness of the glass member increases, the strength of the glass member generally increases.

For example, in case that the glass member has a thickness of 60 micrometers or more, it may be identified that both PEN drop and PEN pressure show strength enhancement of more than 1.9 times and 2.8 times, respectively, compared to a 30 micrometer thickness.

Referring to FIG. 15, repulsive force may increase as the thickness of the glass member increases. For example, in case that the glass member has a thickness of 60 micrometers or more, the repulsive force may increase by about 8 times or more compared to a 30 micrometer thickness. Having high repulsive force may cause deterioration of the folding performance of the glass member.

Therefore, as illustrated in FIG. 6 or FIG. 10, even in case that the thickness of the first glass portion (the first glass portion 610 of FIG. 6 or the first glass portion 1010 of FIG. 10) is thickened to increase rigidity, it is necessary to set an appropriate thickness so that the repulsive force does not increase excessively. As an example, the thickness of the first glass portions 610, 1010 may be 30 micrometers to 60 micrometers, but the disclosure is not limited thereto.

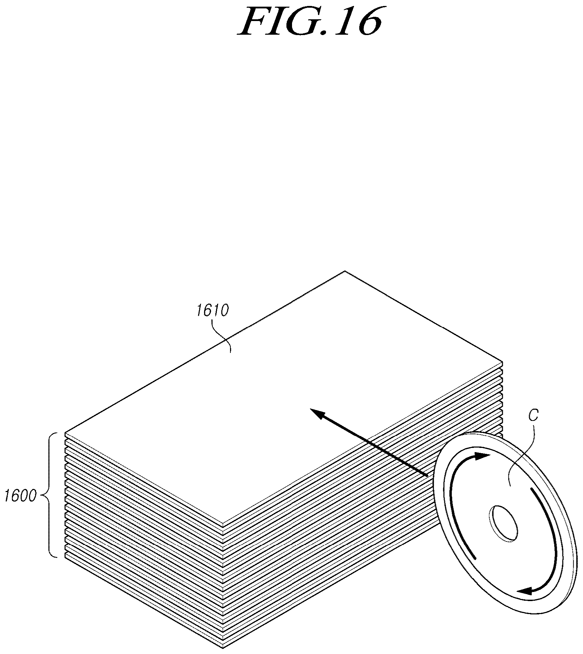

FIG. 16 is an example for describing a method of forming a plurality of recesses in a glass member.

FIG. 16 illustrates one of the methods for forming a plurality of recesses (e.g., the plurality of recesses 830 of FIG. 8 or the plurality of recesses 1040 of FIG. 10) formed in the glass member of FIG. 8 (e.g., the glass member 800 of FIG. 8) or the glass member of FIG. 10 (e.g., the glass member 1000 of FIG. 10).

Referring to FIG. 16, a plurality of recesses 830, 1040 may be formed by a method of stacking a plurality of glass members 1610 and etching the edges of the stacked plurality of glass members 1600. Positions where recesses are to be formed in the stacked plurality of glass members 1600 may be physically etched using an etching tool C. The etching tool C may be, e.g., a computer numerical control (CNC) tool. The etching tool C may include, e.g., a diamond tip or a micro grinding wheel.

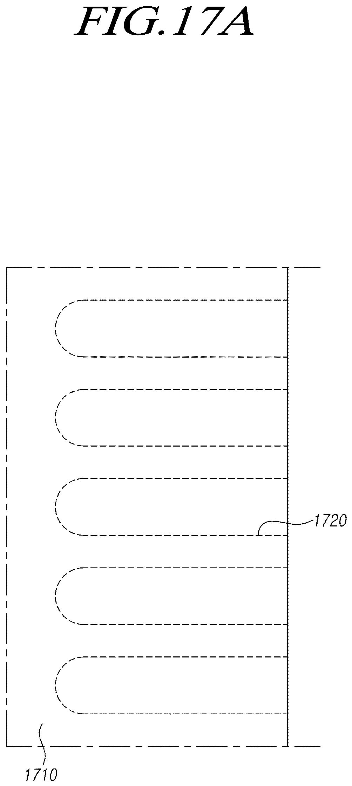

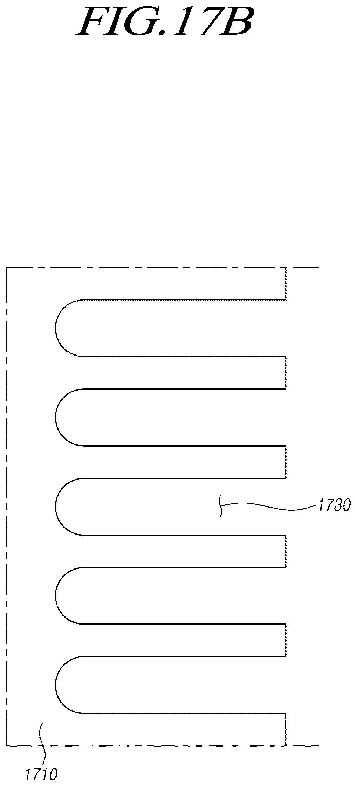

FIGS. 17A and 17B are examples for describing a method of forming a plurality of recesses in a glass member.

FIGS. 17A and 17B show one of the methods for forming a plurality of recesses (e.g., the plurality of recesses 830 of FIG. 8 or the plurality of recesses 1040 of FIG. 10) formed in the glass member of FIG. 8 (e.g., the glass member 800 of FIG. 8) or the glass member of FIG. 10 (e.g., the glass member 1000 of FIG. 10).

Referring to FIGS. 17A and 17B, a plurality of recesses 830, 1040 may be formed by chemical etching. First, as illustrated in FIG. 17A, a process of phase-changing the portion 1720 to be etched in the glass member 1710 may be performed. For example, the portion 1720 to be etched may be phase-changed using a Bessel beam, but the disclosure is not limited thereto.

After phase-changing the portion 1720 to be etched, by exposing the glass member 1710 to an etching solution, a plurality of recesses 1730 may be formed as illustrated in FIG. 17B. Various types of acidic or basic solutions may be used as the etching solution. For example, the etching solution may include ammonium fluoride, sulfuric acid, nitric acid, silicon fluoride, sodium oxide, or hydrofluoric acid.

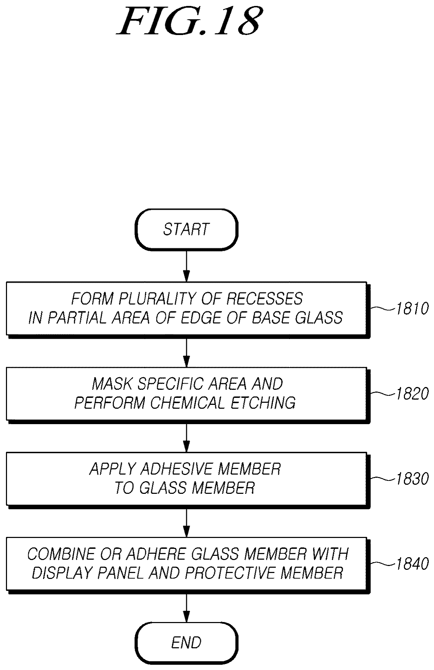

FIG. 18 is a flowchart illustrating a flexible display manufacturing method according to an embodiment.

The manufacturing method of FIG. 18 is described using a flexible display including the glass member 1000 illustrated in FIG. 10 as an example, but the manufacturing method of FIG. 18 may also be applied or adapted in case that manufacturing flexible displays including glass members according to other various embodiments. The manufacturing method of FIG. 18 describes some processes in the manufacturing process of the flexible display.

Referring to FIG. 18, the method for manufacturing the flexible display may include a process 1810 of forming a plurality of recesses in a partial area of the edge of the base glass. The plurality of recesses 1040 may be formed by physical etching or chemical etching. For example, the plurality of recesses 1040 may be formed by the physical etching or chemical etching methods described with reference to FIGS. 16 to 17B.

According to an embodiment, the method for manufacturing the flexible display may include a process 1820 of masking specific areas and performing chemical etching. Here, the specific area may be the first glass portion 1010 or the third glass portion 1030 of the glass member 1000. By chemically etching the unmasked area, a difference in thickness of the glass member 1000 may be formed. For example, the third glass portion 1030 may be appropriately masked so that only a portion is etched. The second glass portion 1020 is not masked and may be etched to be thinner overall. Through process 1820, thickness differentials between the first glass portion 1010, the second glass portion 1020, and the third glass portion 1030 may be formed.

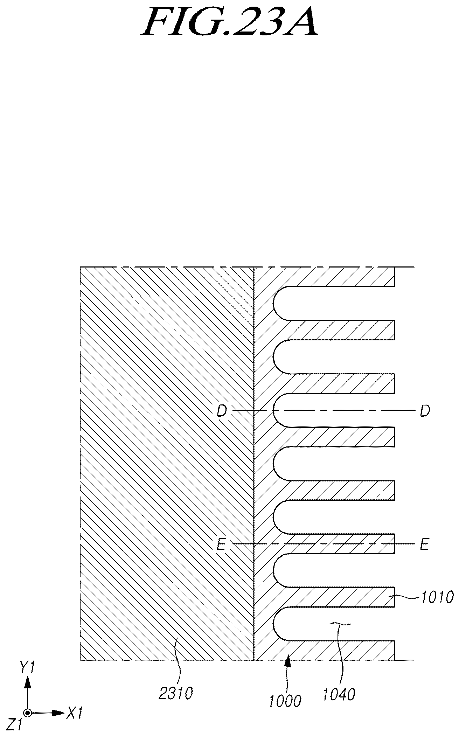

According to an embodiment, the method for manufacturing the flexible display may include a process 1830 of applying an adhesive member to the glass member 1000. Here, the adhesive member may refer to the first adhesive member P1 and the second adhesive member P2 as illustrated in FIG. 4. However, the disclosure is not limited thereto. Since the glass member 1000 has the first glass portion 1010 with relatively thicker thickness and the plurality of recesses 1040 formed, it is necessary to apply the adhesive member differently from existing methods. This is described in detail in FIG. 23A and below.

According to an embodiment, the method for manufacturing the flexible display may include a process 1840 of combining or adhering the glass member 1000 with the display panel (e.g., the display panel 430 of FIG. 4) and the protective member (e.g., the protective member 410 of FIG. 4). The display panel 430 may be combined or adhered to the lower surface of the glass member 1000. The protective member 410 may be combined or adhered to the upper surface of the glass member 1000.

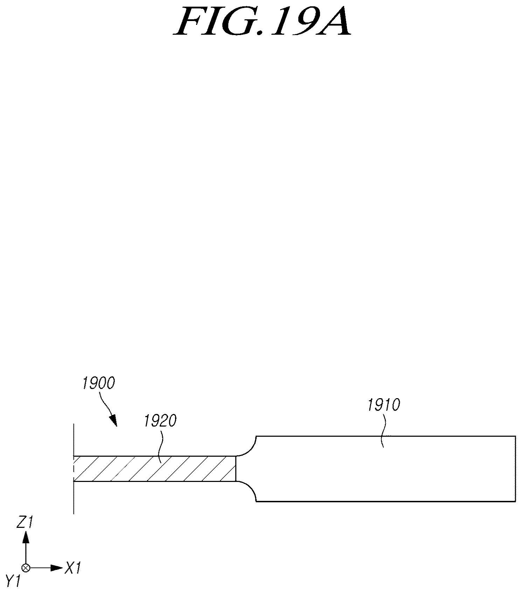

FIGS. 19A to 19D are cross-sectional views illustrating shapes of the first glass portion of a glass member according to various embodiments.

FIGS. 19A to 19D are views illustrating various side shapes of the first glass portions 1910, 1910-1, 1910-2, 1910-3 of the glass members 1900, 1900-1, 1900-2, 1900-3.

A portion of the glass members 1900, 1900-1, 1900-2, 1900-3 illustrated in FIGS. 19A to 19D may be included in the glass member of FIG. 6 (e.g., the glass member 600 of FIG. 6) or the glass member of FIG. 10 (e.g., the glass member 1000 of FIG. 10). Various shapes illustrated in FIGS. 19A to 19D may be applied to the glass member of FIG. 6 (e.g., the glass member 600 of FIG. 6) or the glass member of FIG. 10 (e.g., the glass member 1000 of FIG. 10). The first glass portions 1910, 1910-1, 1910-2, 1910-3 having various shapes illustrated in FIGS. 19A to 19D may replace the first glass portion of FIG. 6 (e.g., the first glass portion 610 of FIG. 6) or the first glass portion of FIG. 10 (e.g., the first glass portion 1010 of FIG. 10). Hereinafter, redundant descriptions of the first glass portion is omitted.

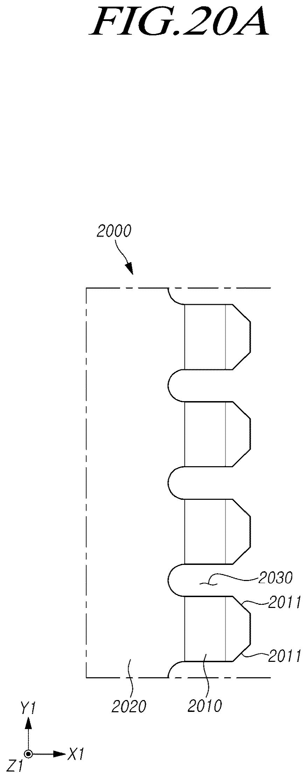

The embodiments of FIGS. 19A to 19D may be selectively combined with the embodiments of FIGS. 1 to 18. The embodiments of FIGS. 19A to 19D may be selectively combined with the embodiments of FIGS. 20A to 33C.

Referring to FIGS. 19A to 19D, the glass members 1900, 1900-1, 1900-2, 1900-3 may include first glass portions 1910, 1910-1, 1910-2, 1910-3 and second glass portions 1920, 1920-1, 1920-2, 1920-3. The first glass portions 1910, 1910-1, 1910-2, 1910-3 may be relatively thicker than the second glass portions 1920, 1920-1, 1920-2, 1920-3. Here, the thickness may compare the average thickness of the first glass portions 1910, 1910-1, 1910-2, 1910-3 with the average thickness of the second glass portions 1920, 1920-1, 1920-2, 1920-3. The first glass portions 1910, 1910-1, 1910-2, 1910-3 may have a vertically symmetrical structure, but the disclosure is not limited thereto.

Referring to FIG. 19A, the connection between the first glass portion 1910 and the second glass portion 1920 may be connected by a curved surface. The connection portion between the first glass portion 1910 and the second glass portion 1920 formed by the thickness difference between the first glass portion 1910 and the second glass portion 1920 may be a portion vulnerable to external pressure (or a portion prone to breakage). If a step is formed between the first glass portion 1910 and the second glass portion 1920, the glass member 1900 becomes vulnerable to breakage, so rigidity may be supplemented by forming a curved surface as illustrated.

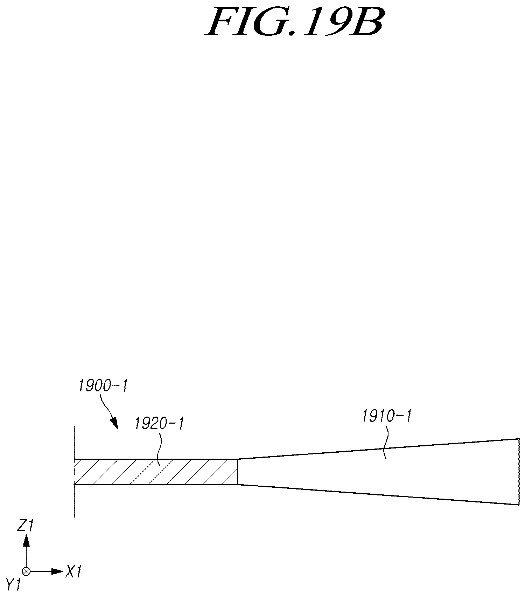

Referring to FIG. 19B, the first glass portion 1910-1 of the glass member 1900-1 may form an inclined surface. In case that the first glass portion 1910-1 extends from the second glass portion 1920-1, it may be formed to be inclined upward as it moves away from the second glass portion 1920-1. The structure illustrated in FIG. 19B is a structure that reduces the step between the first glass portion 1910-1 and the second glass portion 1920-1, and may avoid forming a step that becomes vulnerable to breakage due to thickness difference.

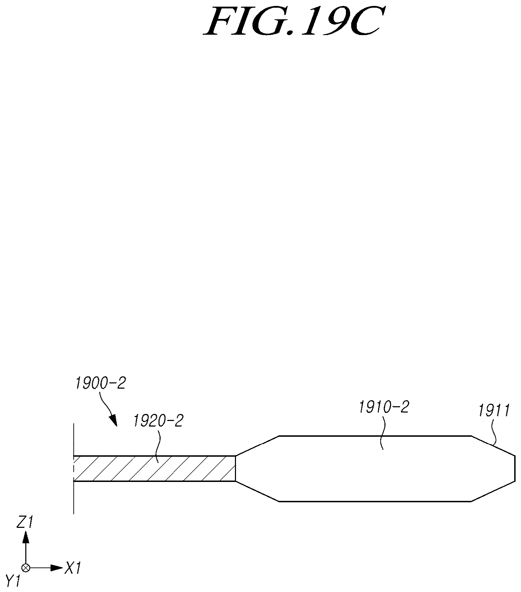

Referring to FIG. 19C, the first glass portion 1910-2 of the glass member 1900-2 may include a chamfered portion 1911. The chamfered portion 1911 may be formed on the outside of the first glass portion 1910-2. The chamfered portion 1911 may be formed at the free end of the first glass portion 1910-2. The chamfered portion 1911 may be a chamfered portion at the corner portion of the first glass portion 1910-2. The chamfered portion 1911 may be formed to be inclined upward or downward at the corner portion of the first glass portion 1910-2. By forming the chamfered portion 1911 on the first glass portion 1910-2, the surface area of the outer surface of the first glass portion 1910-2 may be decreased. In case that the surface area of the outer surface of the first glass portion 1910-2 is decreased, even in case that foreign objects enter the second position (e.g., the second position D2 of FIG. 5), the probability of foreign objects contacting the outer surface of the first glass portion 1910-2 to cause cracks may be decreased.

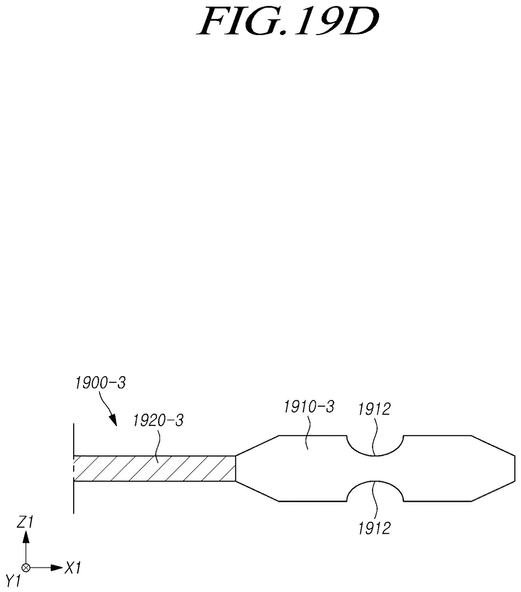

Referring to FIG. 19D, the first glass portion 1910-3 of the glass member 1900-3 may include a groove portion 1912. The groove portion 1912 may be formed on at least one of the upper surface or lower surface of the first glass portion 1910-3. The groove portion 1912 may have an about semicircular cross section or hemispherical shape. However, the shape of the groove portion 1912 is not limited thereto. The groove portion 1912 may distribute applied pressure in case that pressure is applied to the first glass portion 1910-3.

The shape of the first glass portions 1910, 1910-1, 1910-2, 1910-3 is not limited to thereto. For example, the first glass portion may be formed by combining at least two of the shapes illustrated in FIGS. 19A to 19D, and may have various shapes with thickness differences between the first glass portions 1910, 1910-1, 1910-2, 1910-3 and the second glass portions 1920, 1920-1, 1920-2, 1920-3.

FIGS. 20A to 20C are plan views illustrating planar shapes of the first glass portion of a glass member according to various embodiments.

FIGS. 20A to 20C are views illustrating various planar shapes of the plurality of recesses 2030, 2030-1, 2030-2 of the glass members 2000, 2000-1, 2000-2. The plurality of recesses 2030, 2030-1, 2030-2 illustrated in FIGS. 20A to 20C may be included in the glass member of FIG. 8 (e.g., the glass member 800 of FIG. 8) or the glass member of FIG. 10 (e.g., the glass member 1000 of FIG. 10). Various shapes of the plurality of recesses 2030, 2030-1, 2030-2 illustrated in FIGS. 20A to 20C may be applied to the edge portion of the flexible region (e.g., the flexible region 1000b of FIG. 10) of the glass member of FIG. 8 (e.g., the glass member 800 of FIG. 8) or the glass member of FIG. 10 (e.g., the glass member 1000 of FIG. 10). Hereinafter, redundant descriptions of the plurality of recesses and the first glass portion is omitted.

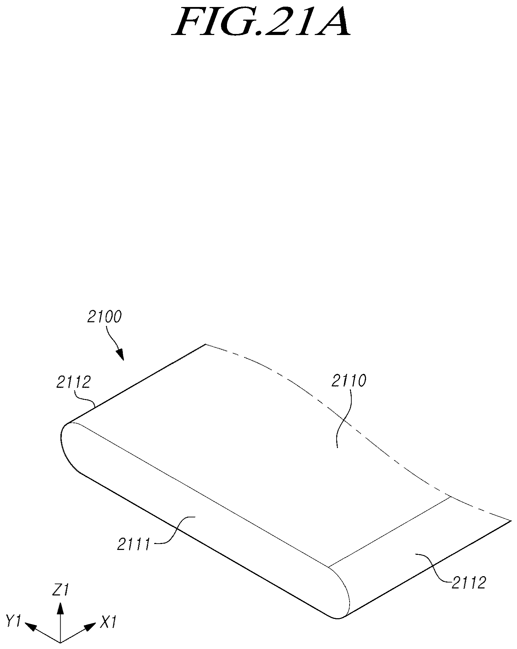

The embodiments of FIGS. 20A to 20C may be selectively combined with the embodiments of FIGS. 1 to 19D. The embodiments of FIGS. 20A to 20C may be selectively combined with the embodiments of FIGS. 21A to 33C.

Referring to FIGS. 20A to 20C, the glass members 2000, 2000-1, 2000-2 may include a plurality of recesses 2030, 2030-1, 2030-2. According to an embodiment, the glass members 2000, 2000-1, 2000-2 may include first glass portions 2010, 2010-1, 2010-2 and second glass portions 2020, 2020-1, 2020-2. One first glass portion 2010, 2010-1, 2010-2 may be disposed between two adjacent recesses 2030, 2030-1, 2030-2.

Referring to FIG. 20A, the glass member 2000 may include a chamfered portion 2011. The first glass portion 2010 may include the chamfered portion 2011. The chamfered portion 2011 may be formed at the outer corner of the first glass portion 2010. The chamfered portion 2011 may be formed by horizontally cutting the outer corner portion of the first glass portion 2010.

According to an embodiment, a portion of the plurality of recesses 2030 may extend with the same width. The plurality of recesses 2030 may extend in width at a portion adjacent to the edge or side surface of the glass member 2000 due to the chamfered portion 2011.

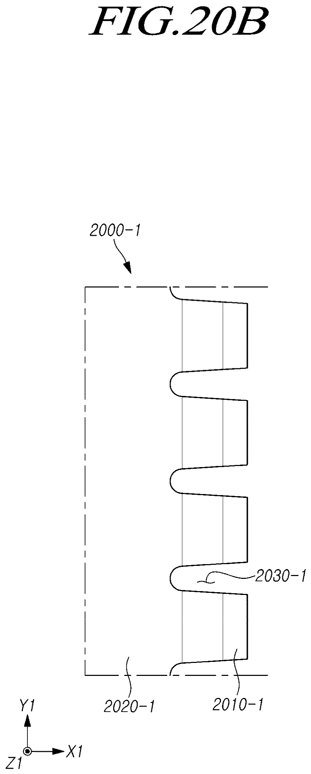

Referring to FIG. 20B, each of the plurality of recesses 2030-1 of the glass member 2000-1 may be formed with variable width. Each of the plurality of recesses 2030-1 may be formed such that the width decreases as it moves away from the edge of the adjacent glass member 2000-1.

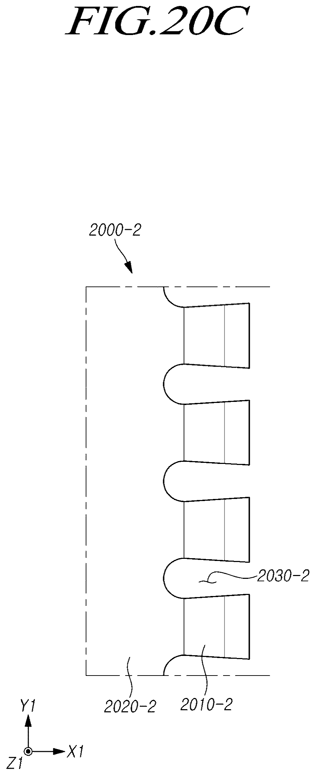

Referring to FIG. 20C, each of the plurality of recesses 2030-2 of the glass member 2000-2 may be formed with variable width. Each of the plurality of recesses 2030-2 may be formed such that the width increases as it moves away from the edge of the adjacent glass member 2000-2.

The shape of the plurality of recesses 2030, 2030-1, 2030-2 is not limited to thereto. For example, the plurality of recesses may be formed by combining at least two of the shapes illustrated in FIGS. 20A to 20C, and may have various shapes recessed inward in the planar direction from the edge portion of the glass members 2000, 2000-1, 2000-2.

FIGS. 21A to 21C are perspective views illustrating the first glass portion of a glass member according to various embodiments.

FIGS. 21A to 21C are views illustrating various shapes of the first glass portions 2110, 2110-1, 2110-2 of the glass members 2100, 2100-1, 2100-2. A portion of the glass members 2100, 2100-1, 2100-2 illustrated in FIGS. 21A to 21C may be included in the glass member of FIG. 8 (e.g., the glass member 800 of FIG. 8) or the glass member of FIG. 10 (e.g., the glass member 1000 of FIG. 10). Various shapes illustrated in FIGS. 21A to 21C may be applied to the glass member of FIG. 8 (e.g., the glass member 800 of FIG. 8) or the glass member of FIG. 10 (e.g., the glass member 1000 of FIG. 10). The first glass portions 2110, 2110-1, 2110-2 having various shapes illustrated in FIGS. 21A to 21C may replace the first glass portion of FIG. 8 (e.g., the first glass portion 810 of FIG. 8) or the first glass portion of FIG. 10 (e.g., the first glass portion 1010 of FIG. 10). Hereinafter, redundant descriptions of the first glass portion is omitted.

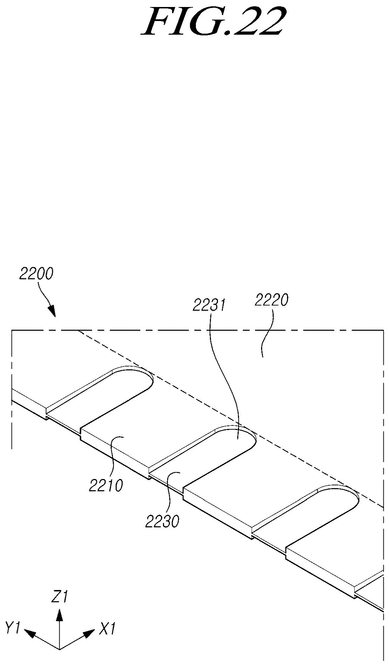

The embodiments of FIGS. 21A to 21C may be selectively combined with the embodiments of FIGS. 1 to 20C. The embodiments of FIGS. 21A to 21C may be selectively combined with the embodiments of FIGS. 22 to 33C.

Referring to FIGS. 21A to 21C, the glass members 2100, 2100-1, 2100-2 may include first glass portions 2110, 2110-1, 2110-2. The first glass portions 2110, 2110-1, 2110-2 may include first side surfaces 2111, 2111-1, 2111-2 and second side surfaces 2112, 2112-1, 2112-2.

According to an embodiment, the first side surfaces 2111, 2111-1, 2111-2 may be side surfaces facing outward from the first glass portions 2110, 2110-1, 2110-2. The first side surfaces 2111, 2111-1, 2111-2 may be a portion of the edge portion of the glass member 2100.

According to an embodiment, the second side surfaces 2112, 2112-1, 2112-2 may be side surfaces extending substantially perpendicular from the first side surfaces 2111, 2111-1, 2111-2. The second side surfaces 2112, 2112-1, 2112-2 may be surfaces facing adjacent recesses. The second side surfaces 2112, 2112-1, 2112-2 may include two side surfaces extending from two opposite ends of the first side surfaces 2111, 2111-1, 2111-2 and parallel to each other.

Referring to FIG. 21A, in the first glass portion 2110 of the glass member 2100, the first side surface 2111 may have an oval or elliptical shape. The first side surface 2111 may have a curved edge portion. According to an embodiment, the second side surface 2112 may include a curved surface.

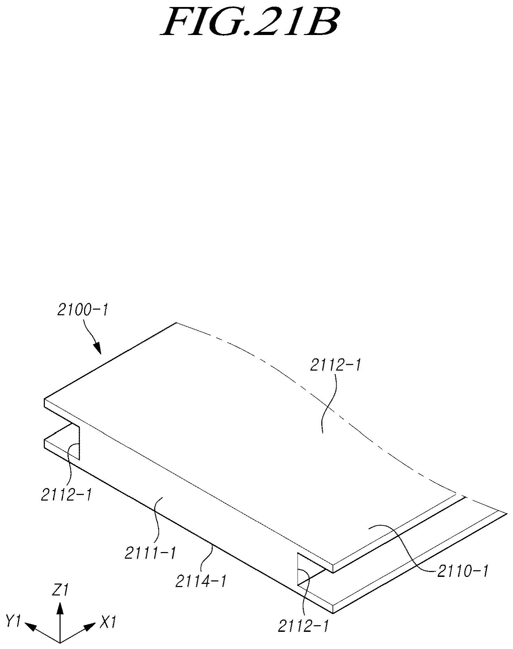

Referring to FIG. 21B, the first glass portion 2110-1 of the glass member 2100-1 may include an upper surface 2113-1 and a lower surface 2114-1 facing opposite to the upper surface 2113-1.

According to an embodiment, the upper surface 2113-1 and lower surface 2114-1 of the first glass portion 2110-1 may be formed such that portions protrude outside of the second side surface 2112-1. The second side surface 2112-1 may be positioned to be recessed inward between the upper surface 2113-1 and the lower surface 2114-1.

According to an embodiment, the first side surface 2111-1 may have an about I-shaped plane. By configuring the cross section of the first glass portion 2110-1 in an about I-shape, the rigidity of the first glass portion 2110-1 may be strengthened.

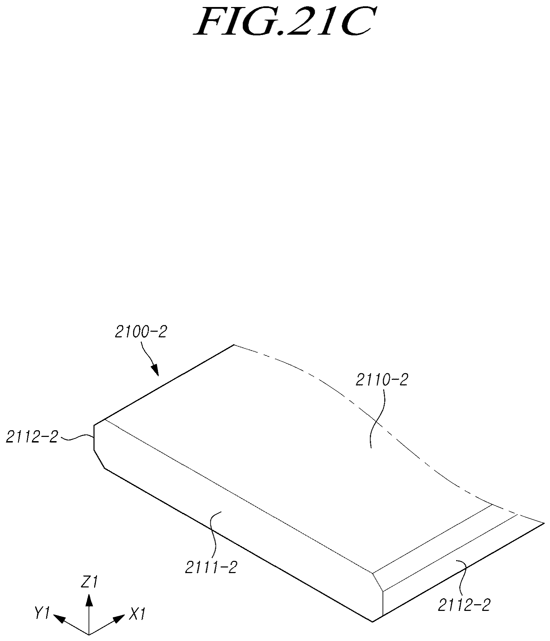

Referring to FIG. 21C, in the first glass portion 2110-2 of the glass member 2100-2, the first side surface 2111-2 may be formed with the edge portion chamfered. The first side surface 2111-2 may have the edge portion cut to form an inclined surface.

The shape of the first glass portions 2110, 2110-1, 2110-2 is not limited to thereto. For example, the first glass portion may be formed by combining at least two of the shapes illustrated in FIGS. 21A to 21C.

FIG. 22 is a perspective view illustrating a portion of a glass member according to an embodiment.

A portion of the glass member 2200 illustrated in FIG. 22 may be included in the glass member of FIG. 8 (e.g., the glass member 800 of FIG. 8) or the glass member of FIG. 10 (e.g., the glass member 1000 of FIG. 10). The plurality of recesses 2230 illustrated in FIG. 22 may be applied to the glass member of FIG. 8 (e.g., the glass member 800 of FIG. 8) or the glass member of FIG. 10 (e.g., the glass member 1000 of FIG. 10). Hereinafter, redundant descriptions of the first glass portion and the second glass portion is omitted.

Referring to FIG. 22, the glass member 2200 may include at least one of a first glass portion 2210, a second glass portion 2220, or a plurality of recesses 2230. The plurality of recesses 2230 may be formed in the first glass portion 2210.

According to an embodiment, the plurality of recesses 2230 may be configured not to penetrate vertically, unlike illustrated in FIG. 8 or FIG. 10. By forming the plurality of recesses 2230 not to penetrate vertically, even in case that force is applied to a portion corresponding to the first glass portion 2210 in the flexible display (e.g., the flexible display 400 of FIG. 4), the display panel (e.g., the display panel 430 of FIG. 4) may be prevented or decreased from being directly exposed to the pressing force.

According to an embodiment, the plurality of recesses 2230 may include a lower surface 2231. The lower surface 2231 may prevent or reduce the display panel (e.g., the display panel 430 of FIG. 4) from being directly exposed from the protective member (e.g., the protective member 410 of FIG. 4).

According to an embodiment, the lower surface 2231 may be formed to be inclined upward toward the planar inside of the glass member 2200. However, without limitation thereto, the lower surface 2231 may be parallel to the upper surface of the glass member 2200, or may be formed to be inclined downward toward the planar inside of the glass member 2200.

FIGS. 23A to 24D are views illustrating a process of applying an adhesive member to a glass member according to an embodiment.

FIGS. 23A to 24D show the adhesive member application process based on the glass member of FIG. 10 (e.g., the glass member 1000 of FIG. 10) for convenience of description. However, without limitation thereto, the application process and structure of the adhesive member illustrated in FIGS. 23A to 24D may also be applied to the glass member of FIG. 6 (e.g., the glass member 600 of FIG. 6) and the glass member of FIG. 8 (e.g., the glass member 800 of FIG. 8).

In the case of the glass members 600, 800, 1000, 1900, 2000, 2100, 2200 according to various embodiments of the disclosure, foreign objects penetration or slippage may occur in case that laminating adhesive members using existing methods. For example, in case of laminating adhesive members on the upper and lower surfaces of the glass member 1000 using existing methods, empty spaces where the adhesive member is not applied may be formed due to the space created by the plurality of recesses 1040, and foreign objects may penetrate into these empty spaces. For example, in case of laminating adhesive members on the upper and lower surfaces of the glass member 1000 using existing methods, slippage may occur in sections where the thickness varies. In the disclosure, methods and structures for addressing the foreign objects penetration or slippage phenomenon are illustrated in FIGS. 23A to 24D.

Although FIGS. 23A to 24D are described using the glass member 1000 of FIG. 10 as an example for convenience of description, it is not limited thereto. The application process and structure of the adhesive member illustrated in FIGS. 23A to 24D may also be applied to various shapes where the thickness on the edge side of the glass member varies or recesses or holes are formed on the edge side.

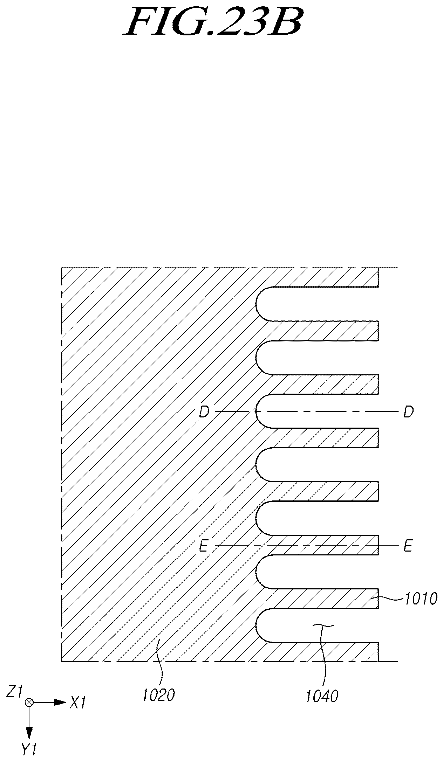

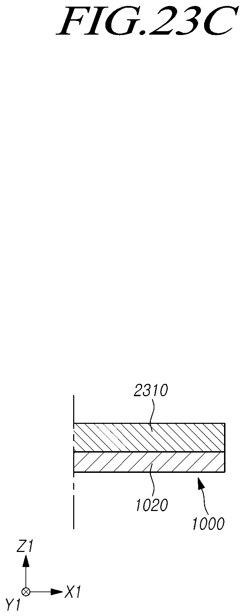

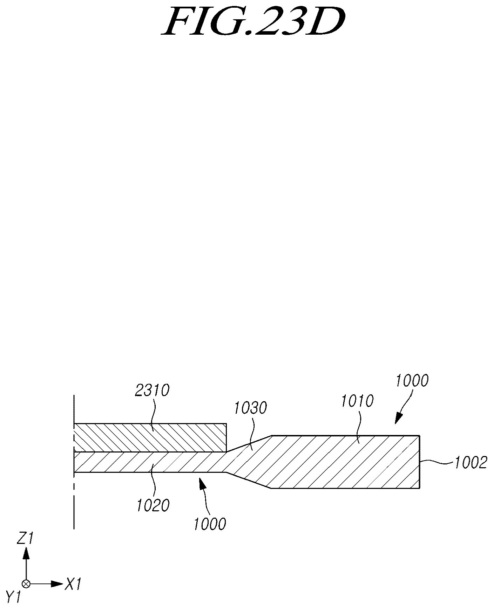

FIG. 23A is a plan view illustrating the glass member 1000 viewed from the front, FIG. 23B is a plan view illustrating the glass member 1000 of FIG. 23A viewed from the rear, FIG. 23C is a cross-sectional view taken along line D-D, and FIG. 23D is a cross-sectional view taken along line E-E.

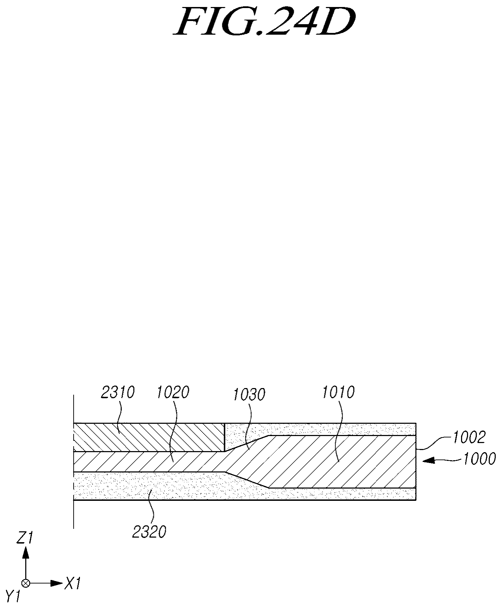

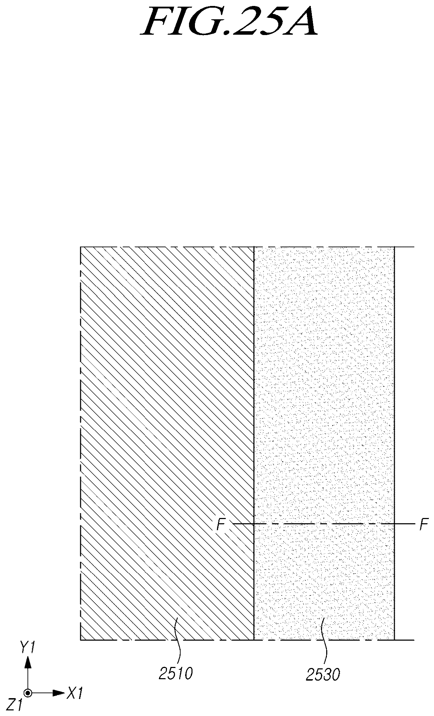

The embodiments of FIGS. 23A to 24D may be selectively combined with the embodiments of FIGS. 1 to 22. The embodiments of FIGS. 23A and 24D may be selectively combined with the embodiments of FIGS. 25A to 33C.

Referring to FIGS. 23A, 23B, 23C, and 23D, a first adhesive member 2310 may be applied or adhered to a portion of the upper surface of the glass member 1000. The first adhesive member 2310 may be positioned on the second glass portion 1020 of the glass member 1000.

According to an embodiment, the first adhesive member 2310 may include at least one of an optically clear adhesive film (OCA), optically clear resin (OCR), pressure sensitive adhesive film (PSA), heat-reactive adhesive, general adhesive, or double-sided tape.

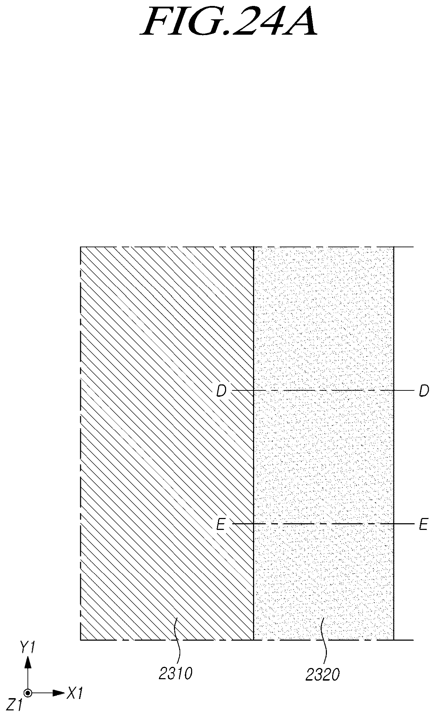

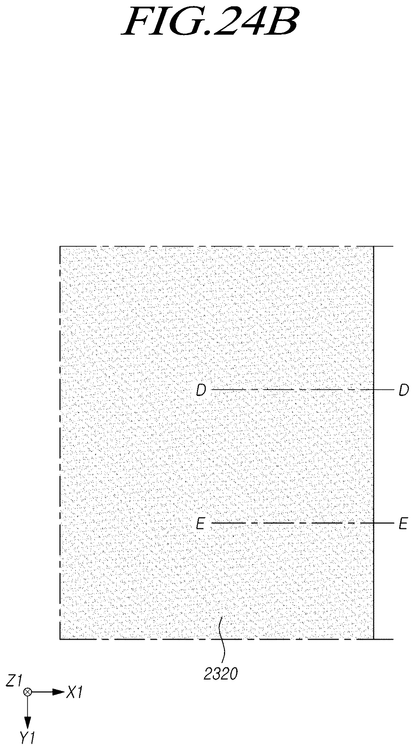

FIG. 24A is a plan view illustrating the glass member 1000 viewed from the front, FIG. 24B is a plan view illustrating the glass member 1000 of FIG. 24A viewed from the rear, FIG. 24C is a cross-sectional view taken along line D-D, and FIG. 24D is a cross-sectional view taken along line E-E.

Referring to FIGS. 24A, 24B, 24C, and 24D, a second adhesive member 2320 may be applied or adhered to the lower surface of the glass member 1000 and the remaining portion of the upper surface of the glass member 1000. Here, the second adhesive member 2320 may be applied in liquid form. Here, the liquid form second adhesive member 2320 may be OCR, but the disclosure is not limited thereto.

According to an embodiment, in case that the liquid form second adhesive member 2320 is applied to the lower surface of the glass member 1000, the liquid form second adhesive member 2320 may penetrate into portions not covered by the first adhesive member 2310. Here, the portions not covered by the first adhesive member 2310 may include portions corresponding to the first glass portion 1010 and the third glass portion 1030 of the upper surface of the glass member 1000 and empty spaces formed by the plurality of recesses 1040.

According to an embodiment, in case that the liquid form second adhesive member 2320 is applied, the second adhesive member 2320 may be applied entirely to the lower surface of the glass member 1000. The second adhesive member 2320 may be applied to the first glass portion 1010 and the third glass portion 1030 of the upper surface of the glass member 1000. The second adhesive member 2320 may be applied within the plurality of recesses 1040 of the glass member 1000.

According to an embodiment, the second adhesive member 2320 may include at least one of an optically clear adhesive film (OCA), optically clear resin (OCR), pressure sensitive adhesive film (PSA), heat-reactive adhesive, general adhesive, or double-sided tape.

According to an embodiment, the glass member 1000 illustrated in FIG. 24A and the first adhesive member 2310 and second adhesive member 2320 laminated to the glass member 1000 may be included in the flexible display of FIG. 4 (e.g., the flexible display 400 of FIG. 4). For example, a protective member (e.g., the protective member 410 of FIG. 4) may be attached to a portion of the second adhesive member 2320 and the first adhesive member 2310 on the upper side of the glass member 1000. For example, a display panel (e.g., the display panel 430 of FIG. 4) may be attached to the second adhesive member 2320 on the lower side of the glass member 1000.

According to an embodiment, the adhesive force of the second adhesive member 2320 may be relatively larger than the adhesive force of the first adhesive member 2310. However, the disclosure is not limited thereto.

According to an embodiment, the elastic modulus (e.g., modulus) of the second adhesive member 2320 may be greater than the elastic modulus of the first adhesive member 2310. The third glass portion 1030 positioned between the first glass portion 1010 and the second glass portion 1020 may be a vulnerable portion prone to breakage as stress may concentrate during bending. Therefore, rigidity may be supplemented by applying the second adhesive member 2320 with a large modulus value around the first glass portion 1010 and the third glass portion 1030.

FIGS. 25A to 25C are views illustrating applying an adhesive member to a glass member according to an embodiment.

FIGS. 25A to 25C show the adhesive member application process based on the glass member of FIG. 10 (e.g., the glass member 1000 of FIG. 10) for convenience of description. However, without limitation thereto, the application process and structure of the adhesive member illustrated in FIGS. 25A to 25C may also be applied to the glass member of FIG. 6 (e.g., the glass member 600 of FIG. 6) and the glass member of FIG. 8 (e.g., the glass member 800 of FIG. 8).

Although FIGS. 25A to 25C are described using the glass member 1000 of FIG. 10 as an example for convenience of description, it is not limited thereto. The structure of the adhesive member illustrated in FIGS. 25A to 25C may also be applied to various shapes where the thickness on the edge side of the glass member varies or recesses or holes are formed on the edge side.

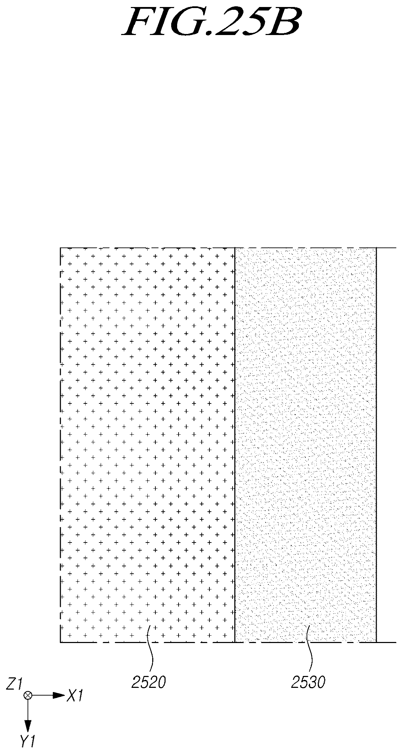

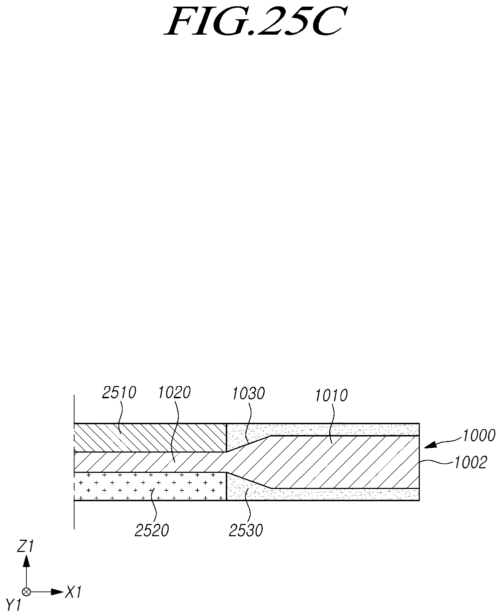

FIG. 25A is a plan view illustrating the glass member 1000 viewed from the front, FIG. 25B is a plan view illustrating the glass member 1000 of FIG. 25A viewed from the rear, and FIG. 25C is a cross-sectional view taken along line F-F.

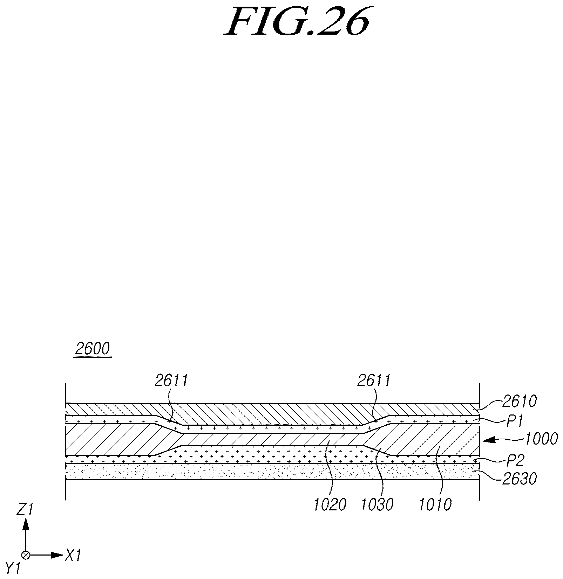

The embodiments of FIGS. 25A to 25C may be selectively combined with the embodiments of FIGS. 1 to 24D. The embodiments of FIGS. 25A and 25C may be selectively combined with the embodiments of FIGS. 26 to 33C.

Referring to FIGS. 25A to 25C, a first adhesive member 2510, a second adhesive member 2520, and a third adhesive member 2530 may be applied or adhered around the glass member 1000.

According to an embodiment, the first adhesive member 2510 may be applied to a portion of the upper surface of the glass member 1000. The upper surface of the glass member 1000 may be the surface to which a protective member (e.g., the protective member 410 of FIG. 4) is adhered. For example, the first adhesive member 2510 may be adhered to the upper surface of the second glass portion 1020.

According to an embodiment, the second adhesive member 2520 may be applied to a portion of the lower surface of the glass member 1000. The lower surface of the glass member 1000 may be the surface to which a display panel (e.g., the display panel 430 of FIG. 4) is adhered. For example, the second adhesive member 2520 may be adhered to the lower surface of the second glass portion 1020.

According to an embodiment, a third adhesive member 2530 may be applied or adhered to the first glass portion 1010 and the third glass portion 1030 of the glass member 1000. Here, the third adhesive member 2530 may be applied in liquid form. Here, the liquid form third adhesive member 2530 may be OCR, but the disclosure is not limited thereto.

According to an embodiment, in case that the liquid form second adhesive member 2520 is applied around the first glass portion 1010 and the third glass portion 1030 of the glass member 1000, the liquid form third adhesive member 2530 may penetrate into portions where steps are formed due to thickness differences and portions where grooves are formed by the plurality of recesses.

According to an embodiment, the first adhesive member 2510, the second adhesive member 2520, or the third adhesive member 2530 may include at least one of an optically clear adhesive film (OCA), optically clear resin (OCR), pressure sensitive adhesive film (PSA), heat-reactive adhesive, general adhesive, or double-sided tape.

According to an embodiment, the glass member 1000 illustrated in FIG. 17 and the first adhesive member 2510, second adhesive member 2520, and third adhesive member 2530 laminated to the glass member 1000 may be included in the flexible display of FIG. 4 (e.g., the flexible display 400 of FIG. 4). For example, a protective member (e.g., the protective member 410 of FIG. 4) may be attached to a portion of the third adhesive member 2530 and the first adhesive member 2510 on the upper side of the glass member 1000. For example, a display panel (e.g., the display panel 430 of FIG. 4) may be attached to a portion of the third adhesive member 2530 and the second adhesive member 2520 on the lower side of the glass member 1000.

According to an embodiment, the adhesive force of the second adhesive member 2520 may be relatively larger than the adhesive force of the first adhesive member 2510. However, the disclosure is not limited thereto.

According to an embodiment, the elastic modulus (e.g., modulus) of the third adhesive member 2530 may be greater than the elastic modulus of the first adhesive member 2510 or the second adhesive member 2520. The third glass portion 1030 positioned between the first glass portion 1010 and the second glass portion 1020 may be a vulnerable portion prone to breakage as stress may concentrate during bending. Therefore, rigidity may be supplemented by applying the third adhesive member 2530 with a large modulus value around the first glass portion 1010 and the third glass portion 1030.

FIG. 26 is a cross-sectional view illustrating a flexible display according to an embodiment.

FIG. 26 illustrates the adhesive member application process based on the glass member of FIG. 10 (e.g., the glass member 1000 of FIG. 10) for convenience of description. However, without limitation thereto, the application process and structure of the adhesive member illustrated in FIG. 26 may also be applied to the glass member of FIG. 6 (e.g., the glass member 600 of FIG. 6) and the glass member of FIG. 8 (e.g., the glass member 800 of FIG. 8).

In the case of the glass members 600, 1000, 1900 according to various embodiments of the disclosure, steps may occur in case of laminating adhesive members using existing methods. For example, in case of laminating adhesive members on the upper and lower surfaces of the glass member 1000 using existing methods, steps may occur in the adhesive member due to the thickness difference between the first glass portions 610, 1010, 1910 and the second glass portions 620, 1020, 1920. Due to steps in the adhesive member, spaces may be created by the steps in case that the glass member 1000 is attached to surrounding components. Alternatively, visibility may deteriorate due to steps in the adhesive member. In the disclosure, methods and structures for addressing the steps or visibility are illustrated in FIG. 26.

Although FIG. 26 is described using the glass member 1000 of FIG. 10 as an example for convenience of description, it is not limited thereto. The structure illustrated in FIG. 26 may also be applied to various shapes where the thickness on the edge side of the glass member varies. Hereinafter, redundant content is omitted.

In FIG. 26, the sizes of the first glass portion 1010 and the third glass portion 1030 are illustrated somewhat exaggerated for convenience of description.

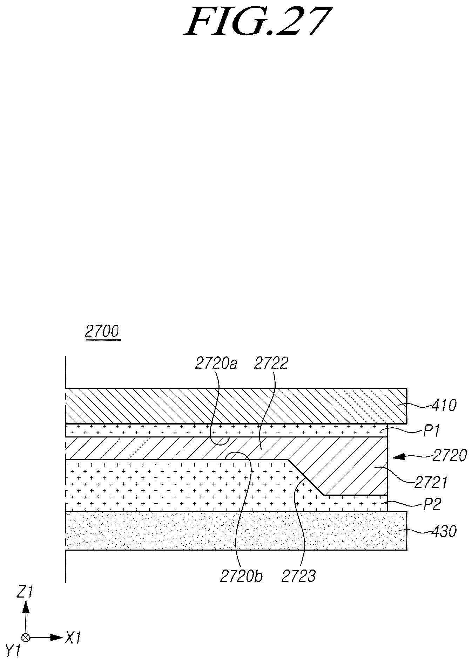

The embodiment of FIG. 26 may be selectively combined with the embodiments of FIGS. 1 to 25C. The embodiment of FIG. 26 may be selectively combined with the embodiments of FIGS. 27 to 33C.

Referring to FIG. 26, the flexible display 2600 may include a protective member 2610, a glass member 1000, or a display panel 2630.

According to an embodiment, the protective member 2610 may have a step structure. According to an embodiment, the protective member 2610 may have a portion protrudingly formed downward. For example, the protective member 2610 may have a portion protrudingly formed toward the glass member 1000. A stepped portion 2611 may be formed on the lower side of the protective member 2610 by the protruding surface. The stepped portion 2611 formed in the protective member 2610 may compensate for the step of the glass member 1000.

According to an embodiment, the refractive index of the protective member 2610 may be substantially the same as the refractive index of the first adhesive member P1.

FIG. 27 is a cross-sectional view illustrating a flexible display according to an embodiment.

For configurations illustrated in FIG. 27 that are substantially the same or similar to configurations illustrated in FIG. 4, the same reference numbers are used. Hereinafter, descriptions of redundant configurations is omitted.

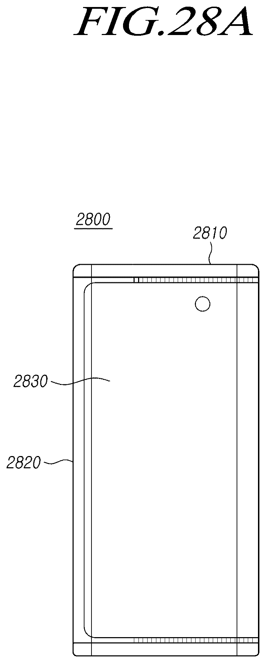

The embodiment of FIG. 27 may be selectively combined with the embodiment of FIGS. 1 to 26. The embodiment of FIG. 27 may be selectively combined with the embodiments of FIGS. 28A to 33C.

Referring to FIG. 27, the flexible display 2700 may include a glass member 2720. The glass member 2720 may be disposed between the protective member 410 and the display panel 430. The glass member 2720 may be adhered to the protective member 410 by the first adhesive member P1. The glass member 2720 may be adhered to the display panel 430 by the second adhesive member P2.

According to an embodiment, the glass member 2720 may include a first glass portion 2721, a second glass portion 2722, and a third glass portion 2723.

According to an embodiment, the first glass portion 2721 may include a portion adjacent from the edge of the glass member 2720. The first glass portion 2721 may include an area within a predetermined distance from the edge of the glass member 2720. For example, the first glass portion 2721 may include an area within a predetermined distance from the edge of the glass member 2720 included in the flexible region (e.g., the flexible region 400b of FIG. 4) in the flexible region 400b. For example, the first glass portion 2721 may include an area within a predetermined interval from the edge portion corresponding to the flexible region 400b among the edges of the glass member 2720. Here, the predetermined interval may be 1 mm or less, but the disclosure is not limited thereto.

The second glass portion 2722 may be a portion different from the first glass portion 2721. The second glass portion 2722 may include at least a portion of the glass member 2720 other than the first glass portion 2721.

According to an embodiment, the thickness of the first glass portion 2721 may be formed relatively thicker than the thickness of the second glass portion 2722. For example, the thickness of the first glass portion 2721 may be thicker than the average thickness of the glass member 2720. The rigidity of the first glass portion 2721 may be relatively stronger than the rigidity of the second glass portion 2722. The thickness difference between the first glass portion 2721 and the second glass portion 2722 may be formed by an etching process using chemicals, but the manufacturing method is not limited thereto.

According to an embodiment, the first glass portion 2721 may be formed to protrude to one side. The first glass portion 2721 may be formed to protrude downward. Accordingly, the upper surface 2720a of the glass member 2720 may be flat, and the lower surface 2720b of the glass member 2720 may have a portion protruding downward. By forming the upper surface 2720a of the glass member 2720 flat, the adhesion between the glass member 2720 and the protective member 410 may be enhanced.

According to an embodiment, the third glass portion 2723 may be provided between the first glass portion 2721 and the second glass portion 2722. The third glass portion 2723 may be a portion connecting the first glass portion 2721 and the second glass portion 2722.

According to an embodiment, the third glass portion 2723 may be formed to be inclined from the second glass portion 2722 toward the first glass portion 2721 on the lower surface 2720b of the glass member 2720. The third glass portion 2723 may be formed to be inclined downward from the first glass portion 2721 toward the second glass portion 2722. However, without limitation thereto, unlike what is illustrated, the third glass portion 2723 may form a step according to the thickness difference between the first glass portion 2721 and the second glass portion 2722.

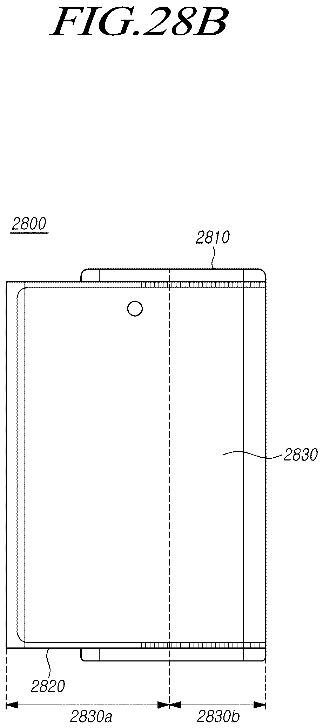

FIGS. 28A and 28B are plan views illustrating a slidable electronic device according to an embodiment.

Referring to FIGS. 28A and 28B, a slidable electronic device 2800 may include a first housing 2810, a second housing 2820, and a flexible display 2830. The slidable electronic device 2800 may refer to any device that varies the display area of the flexible display 2830 visible externally by one housing (e.g., the second housing 2820) sliding relative to another housing (e.g., the first housing 2810).

According to an embodiment, an accommodation space may be provided within the first housing 2810 and/or the second housing 2820. A number of electronic components necessary for operation may be received in the accommodation space.

According to an embodiment, the second housing 2820 may be received within the first housing 2810. The second housing 2820 may be coupled to the first housing 2810 to slide relative to the first housing 2810. In case that the second housing 2820 slides away from the first housing 2810, the display area of the flexible display 2830 may be extended. In case that the second housing 2820 slides closer to the first housing 2810, the display area of the flexible display 2830 may be decreased. Here, the display area may refer to the area of the flexible display 2830 that is visually visible from outside the slidable electronic device 2800.

According to an embodiment, a portion of the flexible display 2830 may be received within the first housing 2810 or the second housing 2820. In case that the second housing 2820 slides outward relative to the first housing 2810, a portion of the flexible display 2830 received within the first housing 2810 or the second housing 2820 may be drawn outward.

According to an embodiment, the flexible display 2830 may include a non-flexible region 2830a and a flexible region 2830b. The non-flexible region 2830a may be a planar region. The non-flexible region 2830a may be a region that is always visually exposed regardless of the movement of the second housing 2820. The flexible region 2830b may be a region that may be received within the first housing 2810 or the second housing 2820. The flexible region 2830b may have a visually exposed area that varies according to the movement of the second housing 2820.

According to an embodiment, the configuration of the flexible display 2830 may be substantially the same or similar to the configuration of the flexible display of FIG. 4 (e.g., the flexible display 400 of FIG. 4).

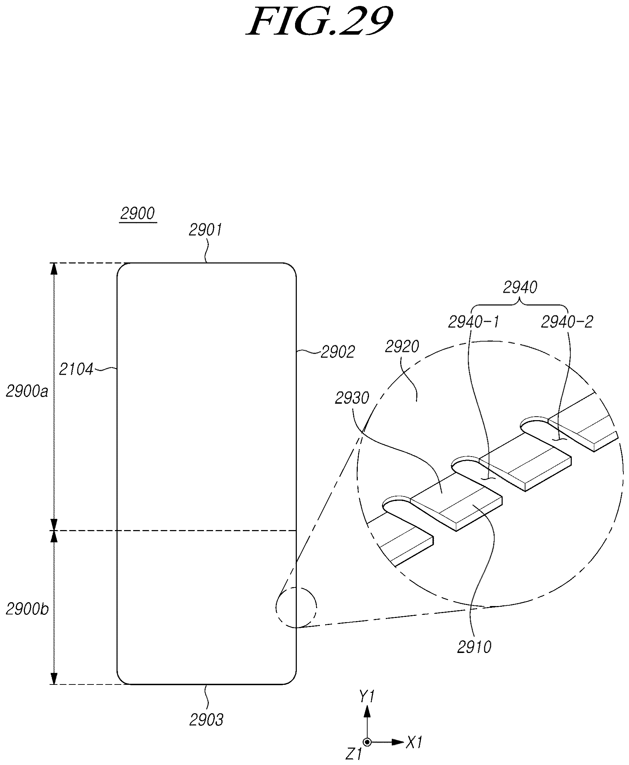

FIG. 29 is a view illustrating a glass member according to an embodiment.

The glass member 2900 illustrated in FIG. 29 may be a component of the flexible display of FIGS. 28A and 28B (e.g., the flexible display 2830 of FIG. 28A).

Referring to FIG. 29, the glass member 2900 may be configured such that at least a portion thereof is deformable. For example, the glass member 2900 may include a non-flexible region 2900a and a flexible region 2900b. Here, the non-flexible region 2900a of the glass member 2900 may correspond to the non-flexible region of FIG. 28B (e.g., the non-flexible region 2830a of FIG. 28B). Here, the flexible region 2900b of the glass member 2900 may correspond to the flexible region 2830b of FIG. 28B.

According to an embodiment, the glass member 2900 may include a first side surface 2901, a second side surface 2902 extending perpendicularly from the first side surface 2901, a third side surface 2903 extending perpendicularly from the second side surface 2902 and parallel to the first side surface 2901, and a fourth side surface 2904 extending perpendicularly from the third side surface 2903 and parallel to the second side surface 2902.

According to an embodiment, the glass member 2900 may include a first glass portion 2910 and a second glass portion 2920.

According to an embodiment, the first glass portion 2910 may include a portion adjacent from the edge of the glass member 2900. The first glass portion 2910 may include an area within a predetermined distance from the edge of the glass member 2900. For example, the first glass portion 2910 may include an area within a predetermined distance from the edge of the glass member 2900 included in the flexible region 2900b in the flexible region 2900b. For example, the first glass portion 2910 may include an area within a predetermined interval from the edge portion corresponding to the flexible region 2900b among the edges of the glass member 2900. For example, the first glass portion 2910 may include an area within a predetermined interval from a portion of the side surface (e.g., the second side surface 2902 or the fourth side surface 2904) of the glass member 2900. Here, the predetermined interval may be 1 mm or less, but the disclosure is not limited thereto.

According to an embodiment, the first glass portion 2910 may have a vertically symmetrical structure. However, it is not limited thereto and may have a shape protruding further to at least one of the upper or lower sides. According to an embodiment, the first glass portion 2910 may have a shape protruding to at least one of the upper or lower sides. For example, one of the upper or lower sides may have a non-protruding shape.

The second glass portion 2920 may be a portion different from the first glass portion 2910. The second glass portion 2920 may include at least a portion of the glass member 2900 other than the first glass portion 2910.

According to an embodiment, the thickness of the first glass portion 2910 may be formed relatively thicker than the thickness of the second glass portion 2920. For example, the thickness of the first glass portion 2910 may be thicker than the average thickness of the glass member 2900. The rigidity of the first glass portion 2910 may be relatively stronger than the rigidity of the second glass portion 2920. The thickness difference between the first glass portion 2910 and the second glass portion 2920 may be formed by an etching process using chemicals, but the manufacturing method is not limited thereto.

According to an embodiment, the first glass portion 2910 may be positioned where it overlaps at least a portion of the area where the protective cap (e.g., the protective cap 510 of FIG. 5) and the protective member (e.g., the protective member 410 of FIG. 5) illustrated in FIG. 5 contact. By forming the first glass portion 2910 relatively thicker than the second glass portion 2920, even in case that foreign objects gets stuck in the first position of FIG. 5 (e.g., the first position D1 of FIG. 5), breakage caused by foreign objects may be efficiently prevented or decreased.

According to an embodiment, the glass member 2900 may include a plurality of recesses 2940. The plurality of recesses 2940 may be formed to be recessed inward from the edge or side surface of the glass member 2900. For example, the plurality of recesses 2940 may be formed inwardly from the outside (or from the edge) of the glass member 2900 on at least one side surface of the glass member 2900. The plurality of recesses 2940 may be formed near the edge corresponding to the flexible region 2900b of the glass member 2900. For example, the plurality of recesses 2940 may be formed to be recessed inward from the edge or side surface corresponding to the flexible region 2900b. The plurality of recesses 2940 may be formed by a physical processing method, laser processing method, or chemical etching method, but the disclosure is not limited thereto.

According to an embodiment, the plurality of recesses 2940 may be formed around the first glass portion 2910. For example, the first glass portion 2910 may have a comb-like shape due to the plurality of recesses 2940, but the disclosure is not limited thereto.

According to an embodiment, the plurality of recesses 2940 may be disposed to be spaced apart at predetermined intervals. For example, the plurality of recesses 2940 may be disposed to be spaced apart at predetermined intervals along the length direction of the glass member 2900. Here, the length direction of the glass member 2900 may refer to the length direction of the second side surface 2902. Here, the predetermined interval may be within 1 micrometer to 1 millimeter, but the disclosure is not limited thereto. For example, the depth of the plurality of recesses 2940 may be within 1 micrometer to 1 millimeter, but the disclosure is not limited thereto. For example, the width of the plurality of recesses 2940 may be within 1 micrometer to 1 millimeter, but the disclosure is not limited thereto.

Since each of the plurality of recesses 2940 is formed with a small size within 1 millimeter, direct impact to the display panel by the plurality of recesses 2940 may be prevented or decreased. For example, even in case that force is applied to the first glass portion 2910 side in the flexible display (e.g., the flexible display 2830 of FIG. 28A), force is not directly applied to the display panel positioned below the first glass portion 2910, and the first glass portion 2910 having an about comb shape may protect the display panel.

According to an embodiment, the spacing between the plurality of recesses 2940 may vary even within the flexible region 2900b.

According to an embodiment, as the first glass portion 2910 of the glass member 2900 has an about comb-like shape due to the plurality of recesses 2940, breakage of the glass member 2900 due to foreign objects intrusion may be prevented or decreased. For example, even in case that foreign objects enter the second position of FIG. 5 (e.g., the second position D2 of FIG. 5), by reducing the side surface area of the first glass portion 2910, the probability of foreign objects contacting the side surface of the glass member 2900 may be decreased.

Even in case that foreign objects contact the first glass portion 2910 of the glass member 2900 and cracks occur on the side surface of the first glass portion 2910, the structural features of the about comb shape may prevent or reduce the expansion of cracks to the entire area of the glass member 2900. Even in case that the flexible region 2900b of the glass member 2900 is bent, stress applied to the first glass portion 2910 may be relatively decreased by the first glass portion 2910 having an about comb shape. In other words, since the stress applied during bending to the first glass portion 2910 formed with the plurality of recesses 2940 is relatively smaller compared to glass without the plurality of recesses 2940 formed, crack expansion may be prevented or decreased.

According to an embodiment, the glass member 2900 may include a third glass portion 2930. The third glass portion 2930 may be positioned between the first glass portion 2910 and the second glass portion 2920. The third glass portion 2930 may be a portion connecting the first glass portion 2910 and the second glass portion 2920.

According to an embodiment, the third glass portion 2930 may be formed to be inclined from the second glass portion 2920 toward the first glass portion 2910. The third glass portion 2930 may be formed to be inclined downward from the first glass portion 2910 toward the second glass portion 2920. However, without limitation thereto, unlike what is illustrated, the third glass portion 2930 may form a step according to the thickness difference between the first glass portion 2910 and the second glass portion 2920.

According to an embodiment, the glass member 2900 may include various shapes of the first glass portion 1910, 2010, 2110, 2210 or a plurality of recesses 2030, 2230 as described with reference to FIGS. 19A to 22.

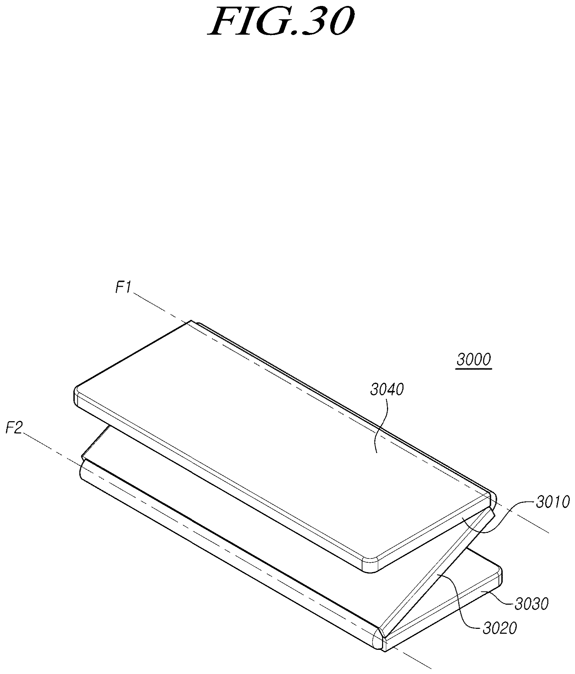

FIG. 30 is a perspective view illustrating a foldable electronic device capable of folding multiple times according to an embodiment.

Referring to FIG. 30, a foldable electronic device 3000 capable of folding multiple times may include a first housing 3010, a second housing 3020, a third housing 3030, and a flexible display 3040. The foldable electronic device 3000 capable of folding multiple times may refer to any device that folds a portion of the flexible display 3040 by rotating one housing relative to another adjacent housing.

According to an embodiment, an accommodation space may be provided within the first housing 3010, the second housing 3020, and/or the third housing 3030. A number of electronic components necessary for operation may be received in the accommodation space.

According to an embodiment, the first housing 3010 may be rotatably coupled to the second housing 3020. According to an embodiment, the second housing 3020 may be rotatably coupled to the third housing 3030. According to an embodiment, the second housing 3020 may be disposed between the first housing 3010 and the third housing 3030.

According to an embodiment, the flexible display 3040 may be received in the first housing 3010, the second housing 3020, and the third housing 3030. For example, the flexible display 3040 may be disposed across the first housing 3010, the second housing 3020, and the third housing 3030. The flexible display 3040 may be bent according to the relative movement of the second housing 3020 with respect to the first housing 3010 and the relative movement of the third housing 3030 with respect to the second housing 3020.

According to an embodiment, the flexible display 3040 may include a first folding axis F1 and a second folding axis F2. The first folding axis F1 may refer to a folding axis of the flexible display 3040 that is bent by the relative rotation of the second housing 3020 with respect to the first housing 3010. The second folding axis F2 may refer to a folding axis of the flexible display 3040 that is bent by the relative rotation of the third housing 3030 with respect to the second housing 3020.

According to an embodiment, in the flexible display 3040, a portion formed to be bent by the first folding axis F1 or the second folding axis F2 may be referred to as a flexible region.

According to an embodiment, the configuration of the flexible display 3040 may be substantially the same or similar to the configuration of the flexible display of FIG. 4 (e.g., the flexible display 400 of FIG. 4).

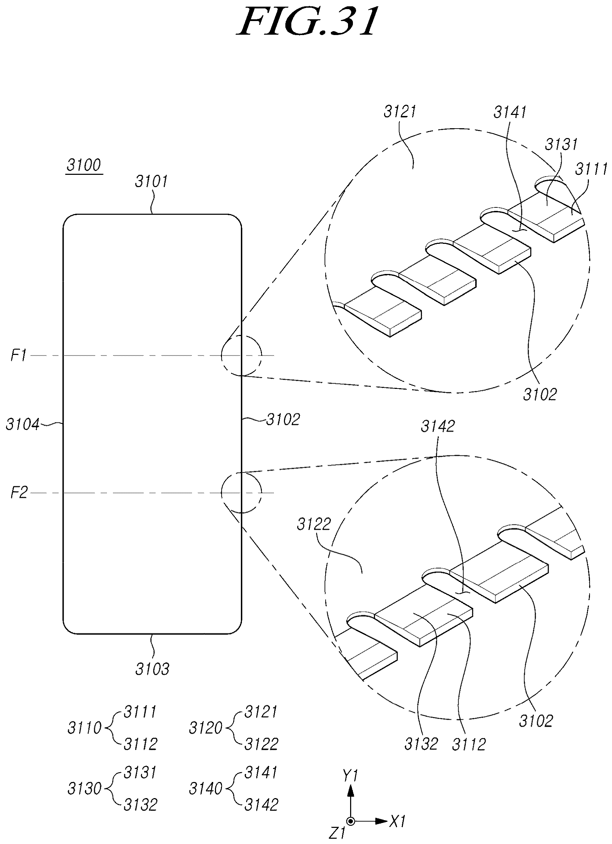

FIG. 31 is a view illustrating a glass member according to an embodiment.

The glass member 3100 illustrated in FIG. 31 may be a component of the flexible display of FIG. 30 (e.g., the flexible display 3040 of FIG. 30).

Referring to FIG. 31, the glass member 3100 may be configured such that at least a portion thereof is deformable. For example, the glass member 3100 may include a first folding axis F1 and a second folding axis F2. Here, the first folding axis F1 of the glass member 3100 may correspond to the first folding axis of FIG. 30 (e.g., the first folding axis F1 of FIG. 30). Here, the second folding axis F2 of the glass member 3100 may correspond to the second folding axis of FIG. 30 (e.g., the second folding axis F2 of FIG. 30).

According to an embodiment, the glass member 3100 may include a first side surface 3101, a second side surface 3102 extending perpendicularly from the first side surface 3101, a third side surface 3103 extending perpendicularly from the second side surface 3102 and parallel to the first side surface 3101, and a fourth side surface 3104 extending perpendicularly from the third side surface 3103 and parallel to the second side surface 3102.

According to an embodiment, the glass member 3100 may include a first glass portion 3110 and a second glass portion 3120.

According to an embodiment, the first glass portion 3110 may include a portion adjacent from the edge of the glass member 3100. The first glass portion 3110 may include an area within a predetermined distance from the edge of the glass member 3100. For example, the first glass portion 3110 may include an area within a predetermined distance from the edge around the first folding axis F1 or the second folding axis F2. For example, the first glass portion 3110 may include an area within a predetermined distance from the edge of the bendable region among the edges of the glass member 3100. For example, the first glass portion 3110 may include an area within a predetermined interval from a portion of the side surface (e.g., the second side surface 3102 or the fourth side surface 3104) of the glass member 3100. Here, the predetermined interval may be 1 mm or less, but the disclosure is not limited thereto.

According to an embodiment, the first glass portion 3110 may have a vertically symmetrical structure. However, it is not limited thereto and may have a shape protruding further to at least one of the upper or lower sides. According to an embodiment, the first glass portion 3110 may have a shape protruding to at least one of the upper or lower sides. For example, one of the upper or lower sides may have a non-protruding shape.

The second glass portion 3120 may be a portion different from the first glass portion 3110. The second glass portion 3120 may include at least a portion of the glass member 3100 other than the first glass portion 3110.

According to an embodiment, the thickness of the first glass portion 3110 may be formed relatively thicker than the thickness of the second glass portion 3120. For example, the thickness of the first glass portion 3110 may be thicker than the average thickness of the glass member 3100. The rigidity of the first glass portion 3110 may be relatively stronger than the rigidity of the second glass portion 3120. The thickness difference between the first glass portion 3110 and the second glass portion 3120 may be formed by an etching process using chemicals, but the manufacturing method is not limited thereto.

According to an embodiment, the first glass portion 3110 may be positioned where it overlaps at least a portion of the area where the protective cap (e.g., the protective cap 510 of FIG. 5) and the protective member (e.g., the protective member 410 of FIG. 5) illustrated in FIG. 5 contact. By forming the first glass portion 3110 relatively thicker than the second glass portion 3120, even in case that foreign objects gets stuck in the first position of FIG. 5 (e.g., the first position D1 of FIG. 5), breakage caused by foreign objects may be efficiently prevented or decreased.

According to an embodiment, the first glass portion 3110 may include a 1-1th glass portion 3111 and a 1-2th glass portion 3112. The 1-1th glass portion 3111 may be disposed around the first folding axis F1. The 1-2th glass portion 3112 may be disposed around the second folding axis F2.

According to an embodiment, the second glass portion 3120 may include a 2-1th glass portion 3121 and a 2-2th glass portion 3122. The 2-1th glass portion 3121 may be disposed around the first folding axis F1. The 2-2th glass portion 3122 may be disposed around the second folding axis F2.

According to an embodiment, the glass member 3100 may include a plurality of recesses 3140. The plurality of recesses 3140 may be formed to be recessed inward from the edge or side surface of the glass member 3100. For example, the plurality of recesses 3140 may be formed inwardly from the outside (or from the edge) of the glass member 3100 on at least one side surface of the glass member 3100. The plurality of recesses 3140 may be formed near the edge corresponding to the first folding axis F1 or the second folding axis F2 of the glass member 3100. For example, the plurality of recesses 3140 may be formed to be recessed inward from the edge or side surface around the first folding axis F1 or the second folding axis F2. The plurality of recesses 3140 may be disposed adjacent to the first glass portion 3110. The plurality of recesses 3140 may be formed by a physical processing method, laser processing method, or chemical etching method, but the disclosure is not limited thereto.

According to an embodiment, the plurality of recesses 3140 may be formed around the first glass portion 3110. For example, the first glass portion 3110 may have a comb-like shape due to the plurality of recesses 3140, but the disclosure is not limited thereto.

According to an embodiment, the plurality of recesses 3140 may be disposed to be spaced apart at predetermined intervals. For example, the plurality of recesses 3140 may be disposed to be spaced apart at predetermined intervals along the length direction of the glass member 3100. Here, the length direction of the glass member 3100 may refer to the length direction of the second side surface 3102. Here, the predetermined interval may be within 1 micrometer to 1 millimeter, but the disclosure is not limited thereto. For example, the depth of the plurality of recesses 3140 may be within 1 micrometer to 1 millimeter, but the disclosure is not limited thereto. For example, the width of the plurality of recesses 3140 may be within 1 micrometer to 1 millimeter, but the disclosure is not limited thereto.

Since each of the plurality of recesses 3140 is formed with a small size within 1 millimeter, direct impact to the display panel by the plurality of recesses 3140 may be prevented or decreased. For example, even in case that force is applied to the first glass portion 3110 side in the flexible display (e.g., the flexible display 1200 of FIG. 12), force is not directly applied to the display panel positioned below the first glass portion 3110, and the first glass portion 3110 having an about comb shape may protect the display panel.

According to an embodiment, the plurality of recesses 3140 may include a first plurality of recesses 3141 and a second plurality of recesses 3142. The first plurality of recesses 3141 may be disposed around the first folding axis F1. The second plurality of recesses 3142 may be disposed around the second folding axis F2.

According to an embodiment, the spacing of the first plurality of recesses 3141 and the spacing of the second plurality of recesses 3142 may be different. For example, the spacing of the first plurality of recesses 3141 may be narrower than the spacing of the second plurality of recesses 3142. However, the disclosure is not limited thereto.

According to an embodiment, the shape of the first plurality of recesses 3141 may be different from the shape of the second plurality of recesses 3142.

According to an embodiment, as the first glass portion 3110 of the glass member 3100 has an about comb-like shape due to the plurality of recesses 3140, breakage of the glass member 3100 due to foreign objects intrusion may be prevented or decreased. For example, even in case that foreign objects enter the second position of FIG. 5 (e.g., the second position D2 of FIG. 5), by reducing the side surface area of the first glass portion 3110, the probability of foreign objects contacting the side surface of the glass member 3100 may be decreased.

Even in case that foreign objects contact the first glass portion 3110 of the glass member 3100 and cracks occur on the side surface of the first glass portion 3110, the structural features of the about comb shape may prevent or reduce the expansion of cracks to the entire area of the glass member 3100. Even in case that the first folding axis F1 or the second folding axis F2 of the glass member 3100 is bent, stress applied to the first glass portion 3110 may be relatively decreased by the first glass portion 3110 having an about comb shape. In other words, since the stress applied during bending to the first glass portion 3110 formed with the plurality of recesses 3140 is relatively smaller compared to glass without the plurality of recesses 3140 formed, crack expansion may be prevented or decreased.

According to an embodiment, the glass member 3100 may include a third glass portion 3130. The third glass portion 3130 may be positioned between the first glass portion 3110 and the second glass portion 3120. The third glass portion 3130 may be a portion connecting the first glass portion 3110 and the second glass portion 3120.

According to an embodiment, the third glass portion 3130 may be formed to be inclined from the second glass portion 3120 toward the first glass portion 3110. The third glass portion 3130 may be formed to be inclined downward from the first glass portion 3110 toward the second glass portion 3120. However, without limitation thereto, unlike what is illustrated, the third glass portion 3130 may form a step according to the thickness difference between the first glass portion 3110 and the second glass portion 3120.

According to an embodiment, the third glass portion 3130 may include a 3-1th glass portion 3131 and a 3-2th glass portion 3132. The 3-1th glass portion 3131 may be disposed around the first folding axis F1. The 3-2th glass portion 3132 may be disposed around the second folding axis F2.

According to an embodiment, the glass member 3100 may include various shapes of the first glass portion 1910, 2010, 2110, 2210 or a plurality of recesses 2030, 2230 as described with reference to FIGS. 19A to 22.

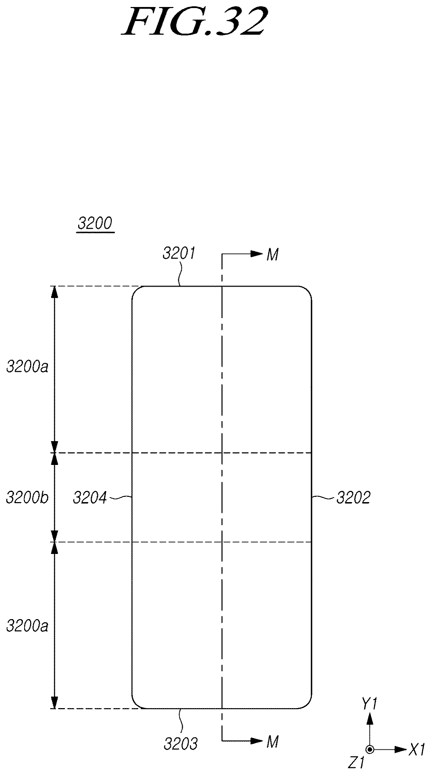

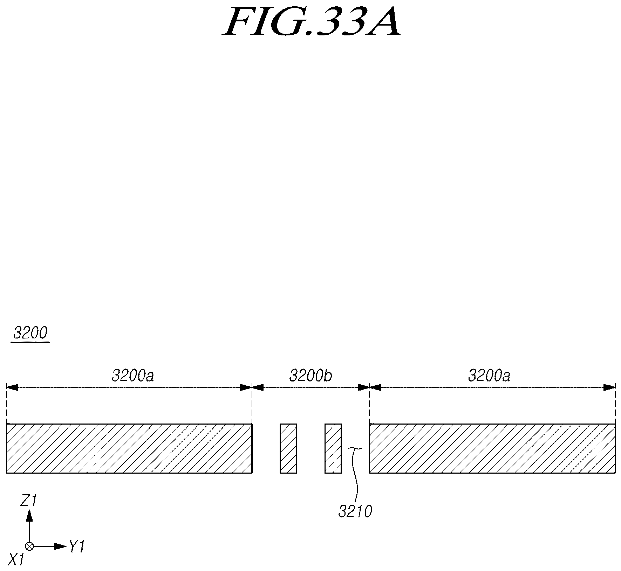

FIG. 32 is a view illustrating a glass member according to an embodiment. FIGS. 33A to 33C are cross-sectional views taken along line M-M in FIG. 32.

The glass members 3200, 3200-1, 3200-2 illustrated in FIGS. 32 to 33C are for describing various structures for improving the bending performance of the flexible region (e.g., 3200b) as examples, and may be applied to the flexible region of all the above-described glass members.

The glass member 3200 illustrated in FIG. 32 may be included in the flexible display illustrated in FIG. 4 (e.g., the flexible display 400 of FIG. 4). The glass member 3200 illustrated in FIG. 32 may be substantially the same or similar configuration as the glass member illustrated in FIG. 4 (e.g., the glass member 420 of FIG. 4). Alternatively, the glass member 3200 illustrated in FIG. 32 may replace the glass member (e.g., the glass member 420 of FIG. 4) in the flexible display illustrated in FIG. 4 (e.g., the flexible display 400 of FIG. 4).

Referring to FIG. 32, the glass member 3200 may include a non-flexible region 3200a and a flexible region 3200b. Here, the non-flexible region 3200a of the glass member 3200 may correspond to the non-flexible region of FIG. 4 (e.g., the non-flexible region 400a of FIG. 4). Here, the flexible region 3200b of the glass member 3200 may correspond to the flexible region of FIG. 4 (e.g., the flexible region 400b of FIG. 4).

According to an embodiment, the glass member 3200 may include a first side surface 3201, a second side surface 3202 extending perpendicularly from the first side surface 3201, a third side surface 3203 extending perpendicularly from the second side surface 3202 and parallel to the first side surface 3201, and a fourth side surface 3204 extending perpendicularly from the third side surface 3203 and parallel to the second side surface 3202.

FIGS. 33A to 33C show various shapes formed in the flexible region 3200b of the glass member 3200.

Referring to FIG. 33A, the glass member 3200 may include a hole or slit 3210. The hole or slit 3210 may be formed in the flexible region 3200b. By forming the hole or slit 3210 in the flexible region 3200b, the bending performance of the glass member 3200 may be enhanced.

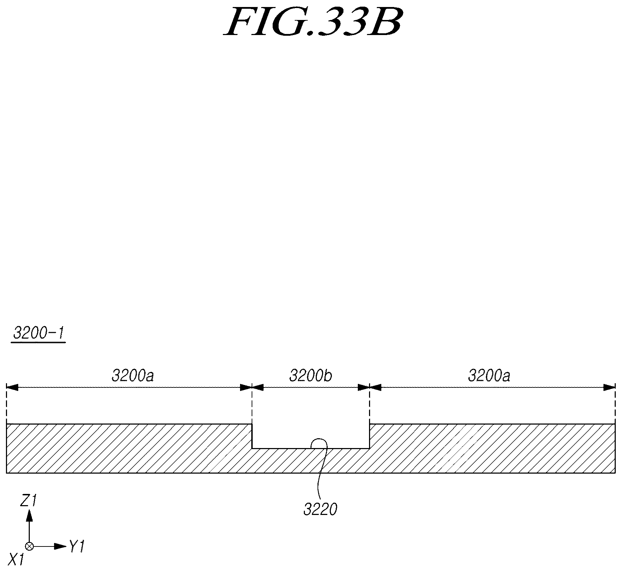

Referring to FIG. 33B, the glass member 3200-1 may include a groove portion 3220. The groove portion 3220 may be formed in the flexible region 3200b. By forming the groove portion 3220 in the flexible region 3200b, the thickness of the glass member 3200-1 in the flexible region 3200b may be decreased. As a result, repulsive force may be decreased and bending performance may be enhanced.

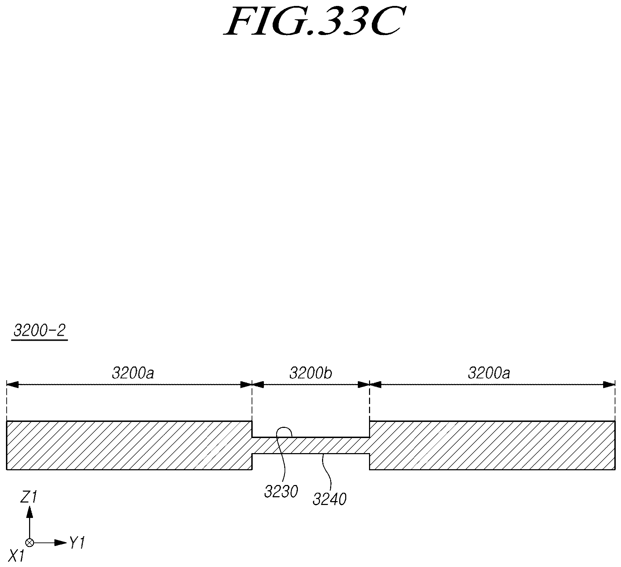

Referring to FIG. 33C, the glass member 3200-2 may include a first groove portion 3230 and a second groove portion 3240. The first groove portion 3230 and the second groove portion 3240 may each be disposed in the flexible region of the glass member 3200-2. The first groove portion 3230 may be formed, e.g., on the upper surface (e.g., the surface facing the +Z1 direction) of the glass member 3200-2. The second groove portion 3240 may be formed, e.g., on the lower surface (e.g., the surface facing the -Z1 direction) of the glass member 3200-2. The first groove portion 3230 and the second groove portion 3240 may be formed to overlap each other vertically. By forming the first groove portion 3230 and the second groove portion 3240, the bending performance of the glass member 3200-2 in the flexible region 3200b may be enhanced.

An electronic device 200, 2800, 3000 according to an embodiment may include a first housing 210, 2810, 3010, a second housing 220, 2820, 3020 coupled to be movable or rotatable with respect to the first housing 210, 2810, 3010, and a flexible display 230, 2830, 3040 received in the first housing 210, 2810, 3010 and the second housing 220, 2820, 3020 and configured such that at least a portion thereof is deformable. The flexible display 230, 2830, 3040 may include a deformable display panel 430 and a glass member 800, 1000, 2900, 3100 positioned on the deformable display panel 430 and configured to be deformable. The glass member 800, 1000, 2900, 3100 may include a plurality of recesses 830, 1040, 2940, 3140 formed inwardly from an outside of the glass member 800, 1000, 2900, 3100 on at least one side surface.

According to an embodiment, the glass member 800, 1000, 2900, 3100 may include a first glass portion 810, 1010, 2910, 3110 positioned between the plurality of recesses 830, 1040, 2940, 3140 and having a first thickness, and a second glass portion 820, 1020, 2920, 3120 positioned in a planar inward direction of the glass member 800, 1000, 2900, 3100 relative to the first glass portion 810, 1010, 2910, 3110 and having a second thickness different from the first thickness. For example, the second glass portion 820, 1020, 2920, 3120 may be positioned farther from the edge of the glass member 800, 1000, 2900, 3100 than the first glass portion 810, 1010, 2910, 3110.

According to an embodiment, the first thickness may be relatively thicker than the second thickness.

According to an embodiment, the glass member 1000, 2900, 3100 may include a third glass portion 1030, 2930, 3130 extending between the first glass portion 1010, 2910, 3110 and the second glass portion 1020, 2920, 3120. The third glass portion 1030, 2930, 3130 may be configured to progressively become thinner from the first glass portion 1010, 2910, 3110 toward the second glass portion 1020, 2920, 3120. For example, the third glass portion 1030, 2930, 3130 may be formed to progressively become thinner as it moves away from the edge of the glass member 1000, 2900, 3100.

According to an embodiment, the flexible display 230, 2830, 3040 may further include a first adhesive member P1 adhered around the first glass portion 810, 1010, 2910, 3110 and a second adhesive member P2 adhered to one surface of the second glass portion 820, 1020, 2920, 3120 and having a different modulus value from the first adhesive member P1.

According to an embodiment, a modulus value of the first adhesive member P1 may be relatively larger than a modulus value of the second adhesive member P2.

According to an embodiment, in case that the glass member 800, 1000, 2900, 3100 is in a bent state, tensile stress of the first glass portion 810, 1010, 2910, 3110 may be relatively smaller than tensile stress of the bent portion of the second glass portion 820, 1020, 2920, 3120.

According to an embodiment, the plurality of recesses 830, 1040, 2940, 3140 may be formed such that a width thereof varies in an inward direction from one side surface of the glass member 800, 1000, 2900, 3100.

According to an embodiment, the plurality of recesses 830, 1040, 2940, 3140 may have substantially the same width.

According to an embodiment, the plurality of recesses 830, 1040, 2940, 3140 may have a width L1 of 1 micrometer to 1000 micrometers.

According to an embodiment, the plurality of recesses 830, 1040, 2940, 3140 may have a depth L2 of 1 micrometer to 1000 micrometers.

According to an embodiment, the plurality of recesses 830, 1040, 2940, 3140 may be disposed to be spaced apart with a spacing L3 of 1 micrometer to 1000 micrometers.

According to an embodiment, the plurality of recesses 830, 1040, 2940, 3140 may be configured not to penetrate through the glass member 800, 1000, 2900, 3100 vertically.

According to an embodiment, the flexible display may further include a printing layer 440 disposed along an edge of the flexible display. The plurality of recesses 830, 1040, 2940, 3140 may be disposed to overlap the printing layer 440 vertically.

A flexible display according to an embodiment may include a deformable display panel 430 and a glass member 800, 1000, 2900, 3100 positioned on the deformable display panel 430 and configured to be deformable. The glass member 800, 1000, 2900, 3100 may include a plurality of recesses 830, 1040, 2940, 3140 formed inwardly from an outside (or from an edge) of the glass member 800, 1000, 2900, 3100 on at least one side surface.

According to an embodiment, the glass member 800, 1000, 2900, 3100 may include a first glass portion 810, 1010, 2910, 3110 positioned between the plurality of recesses 830, 1040, 2940, 3140 and having a first thickness, and a second glass portion 820, 1020, 2920, 3120 positioned in a planar inward direction of the glass member 800, 1000, 2900, 3100 relative to the first glass portion 810, 1010, 2910, 3110 and having a second thickness relatively thinner than the first thickness. For example, the second glass portion 820, 1020, 2920, 3120 may be positioned farther from the edge of the glass member 800, 1000, 2900, 3100 than the first glass portion 810, 1010, 2910, 3110.

According to an embodiment, the glass member 1000, 2900, 3100 includes a third glass portion 1030, 2930, 3130 extending between the first glass portion 1010, 2910, 3110 and the second glass portion 1020, 2920, 3120, and the third glass portion 1030, 2930, 3130 may be configured to progressively become thinner from the first glass portion 1010, 2910, 3110 toward the second glass portion 1020, 2920, 3120.

According to an embodiment, the flexible display may further include a first adhesive member P1 adhered around the first glass portion 810, 1010, 2910, 3110 and a second adhesive member P2 adhered to one surface of the second glass portion 820, 1020, 2920, 3120 and having a modulus value relatively larger than the first adhesive member P1.

According to an embodiment, the plurality of recesses 830, 1040, 2940, 3140 may have a width of 1 micrometer to 1000 micrometers, have a depth of 1 micrometer to 1000 micrometers, and be disposed to be spaced apart with a spacing of 1 micrometer to 1000 micrometers.

According to an embodiment, the flexible display 230, 2830, 3040 further includes a printing layer 440 disposed along an edge of the flexible display 230, 2830, 3040, and the plurality of recesses 830, 1040, 2940, 3140 may be disposed to overlap the printing layer 440 vertically.

The terms as used herein are provided merely to describe some embodiments thereof, but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments.

## Claims

1. An electronic device, comprising:
a first housing (210, 2810, 3010);
a second housing (220, 2820, 3020) coupled to be movable or rotatable with respect to the first housing (210, 2810, 3010); and
a flexible display (230, 2830, 3040) received in the first housing (210, 2810, 3010) and the second housing (220, 2820, 3020) and configured such that at least a portion thereof is deformable, wherein the flexible display (230, 2830, 3040) comprises,
a deformable display panel (430); and
a glass member (800, 1000, 2900, 3100) positioned on the deformable display panel (430) and configured to be deformable,
wherein the glass member (800, 1000, 2900, 3100) includes a plurality of recesses (830, 1040, 2940, 3140) formed inwardly from an outside of the glass member (800, 1000, 2900, 3100) on at least one side surface.

2. The electronic device of claim 1, wherein the glass member (800, 1000, 2900, 3100) comprises a first glass portion (810, 1010, 2910, 3110) positioned between the plurality of recesses (830, 1040, 2940, 3140) and having a first thickness, and a second glass portion (820, 1020, 2920, 3120) positioned in a planar inward direction of the glass member (800, 1000, 2900, 3100) relative to the first glass portion (810, 1010, 2910, 3110) and having a second thickness different from the first thickness.

3. The electronic device of claim 2, wherein the first thickness is relatively larger than the second thickness.

4. The electronic device of claim 2 or 3, wherein the glass member (1000, 2900, 3100) comprises a third glass portion (1030, 2930, 3130) extended between the first glass portion (1010, 2910, 3110) and the second glass portion (1020, 2920, 3120), and
wherein the third glass portion (1030, 2930, 3130) is configured to progressively become thinner from the first glass portion (1010, 2910, 3110) toward the second glass portion (1020, 2920, 3120).

5. The electronic device of any one of claims 2 to 4, wherein the flexible display (230, 2830, 3040) further comprises a first adhesive member (P1) adhered around the first glass portion (810, 1010, 2910, 3110) and a second adhesive member (P2) adhered to one surface of the second glass portion (820, 1020, 2920, 3120) and having a different modulus value from the first adhesive member (P1),
wherein a modulus value of the first adhesive member (P1) is relatively larger than a modulus value of the second adhesive member (P2).

6. The electronic device of any one of claims 1 to 5, wherein the plurality of recesses (830, 1040, 2940, 3140) are formed such that a width thereof varies in an inward direction from one side surface of the glass member (800, 1000, 2900, 3100).

7. The electronic device of any one of claims 1 to 6, wherein the plurality of recesses (830, 1040, 2940, 3140) have a width (L1) of 1 micrometer to 1000 micrometers, have a depth (L2) of 1 micrometer to 1000 micrometers, and are arranged spaced apart with a spacing (L3) of 1 micrometer to 1000 micrometers.

8. The electronic device of any one of claims 1 to 7, wherein the plurality of recesses (830, 1040, 2940, 3140) are configured not to penetrate through the glass member (800, 1000, 2900, 3100) vertically.

9. The electronic device of any one of claims 1 to 8, further comprising a printing layer (440) disposed along an edge of the flexible display,
wherein the plurality of recesses (830, 1040, 2940, 3140) are disposed to overlap the printing layer (440) vertically.

10. A flexible display, comprising:
a deformable display panel (430); and
a glass member (800, 1000, 2900, 3100) positioned on the deformable display panel (430) and configured to be deformable,
wherein the glass member (800, 1000, 2900, 3100) includes a plurality of recesses (830, 1040, 2940, 3140) formed inwardly from an outside of the glass member (800, 1000, 2900, 3100) on at least one side surface.

11. The flexible display of claim 10, wherein the glass member (800, 1000, 2900, 3100) comprises a first glass portion (810, 1010, 2910, 3110) positioned between the plurality of recesses (830, 1040, 2940, 3140) and having a first thickness, and a second glass portion (820, 1020, 2920, 3120) positioned in a planar inward direction of the glass member (800, 1000, 2900, 3100) relative to the first glass portion (810, 1010, 2910, 3110) and having a second thickness relatively thinner than the first thickness.

12. The flexible display of claim 11, wherein the glass member (1000, 2900, 3100) comprises a third glass portion (1030, 2930, 3130) extended between the first glass portion (1010, 2910, 3110) and the second glass portion (1020, 2920, 3120), and
wherein the third glass portion (1030, 2930, 3130) is configured to progressively become thinner from the first glass portion (1010, 2910, 3110) toward the second glass portion (1020, 2920, 3120).

13. The flexible display of claim 11 or 12, further comprising a first adhesive member (P1) adhered around the first glass portion (810, 1010, 2910, 3110) and a second adhesive member (P2) adhered to one surface of the second glass portion (820, 1020, 2920, 3120) and having a modulus value relatively larger than the first adhesive member (P1).

14. The flexible display of any one of claims 10 to 13, wherein the plurality of recesses (830, 1040, 2940, 3140) have a width of 1 micrometer to 1000 micrometers, have a depth of 1 micrometer to 1000 micrometers, and are arranged spaced apart with a spacing of 1 micrometer to 1000 micrometers.

15. The flexible display of any one of claims 10 to 14, wherein the flexible display (230, 2830, 3040) further comprises a printing layer (440) disposed along an edge of the flexible display (230, 2830, 3040), and
wherein the plurality of recesses (830, 1040, 2940, 3140) are disposed to overlap the printing layer (440) vertically.
